(19) Europäisches Patentamt
European Patent Office
Office européen des brevets

(11) EP 2 843 681 A1

(12) **EUROPEAN PATENT APPLICATION**

(43) Date of publication:
**04.03.2015 Bulletin 2015/10**

(21) Application number: **14180184.5**

(22) Date of filing: **07.08.2014**

(51) Int Cl.:
***H01H 47/00*** *(2006.01)* *B60L 3/00* *(2006.01)*
*G01R 31/327* *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **26.08.2013 JP 2013174679**

(71) Applicants:
- **FUJITSU LIMITED**
**Kawasaki-shi,**
**Kanagawa 211-8588 (JP)**
- **FUJITSU TEN LIMITED**
**Kobe-shi**
**Hyogo 652-8510 (JP)**
- **Transtron, Inc.**
**yokohama-shi,**
**Kanagawa 222-0033 (JP)**

(72) Inventors:
- **Yonezaki, Keiichi**
**Hyogo, 652-8510 (JP)**
- **Nakamura, Shinji**
**Hyogo, 652-8510 (JP)**
- **Miyamoto, Masaki**
**Hyogo, 652-8510 (JP)**
- **Sasaki, Jun**
**Kanagawa, 222-0033 (JP)**
- **Nishijima, Kazutoshi**
**Kanagawa, 222-0033 (JP)**
- **Ogura, Yousuke**
**Kanagawa, 222-0033 (JP)**

(74) Representative: **Hoffmann Eitle**
**Patent- und Rechtsanwälte PartmbB**
**Arabellastraße 30**
**81925 München (DE)**

# (54) Diagnosis apparatus and diagnosis method for relay circuit

(57) An example of a relay circuit includes: a capacitor (C) connecting both ends of a load circuit (30 and 40); first and second main relays (81 and 82) disposed in power supply lines between a direct-current power supply (50) and the load circuit (30 and 40); a series circuit configured by a first resistor (R1) and a precharge relay (83) disposed in parallel with the first main relay (81); and a second resistor (R2) connecting both ends of the load circuit (30 and 40). A discharge process is performed in which both the first main relay (81) and the precharge relay (83) are turned on, the second main relay (82) is turned off, and a reactive current is caused to flow through the load circuit (30 and 40). In this discharge process, an abnormality of the first resistor (R1) is detected based on a both-end voltage (V) of the capacitor (C) detected by a voltage sensor (70) and a resistance value ($R_{dis}$) that is an equivalent representation of the discharge process.

FIG. 1

RELAY CONT. SIGNAL
VCU
MCU (MOTOR CONTROL UNIT)
SPI COM.
INVERTER CONT.
INVERTER VOL.
GND
INVERTER
UH
VH
WH
UL
VL
WL
VDC
ISOLATION AMP
THREE-PHASE MOTOR
CURRENT SENSOR
ANGLE SENSOR
VOLTAGE SENSOR
LIB P
LIB PRE
LIB N
LiB (V1)
C
R1
R2

EP 2 843 681 A1

**Description**

FIELD

The embodiments discussed herein are related to a diagnosis apparatus and a diagnosis method for a relay circuit.

BACKGROUND

A DC power supply available to flow a large current with a voltage of 200 V or higher may be used for electric vehicles or hybrid vehicles, for example. Accordingly, for the purpose of security and the like, a relay contact may be provided in a power supply line so as to completely separate the DC power supply from a load circuit such as an inverter or a motor when the DC power supply is not in use.

However, the relay contact may be welded due to discharges occurred during on-off control of the relay contact. As examples of technologies for diagnosing such welding, technologies disclosed in JP 2000-278802 A and WO 2004/088696 A are known.

JP 2000-278802 A discloses a system which determines a malfunction in a discharging system for discharging electric charge accumulated in a capacitor by using a motor coil. This determination system can determine whether discharge is performed normally, whether there is an abnormality of the motor coil, and whether there is an abnormality of a discharge resistor, based on a change (slope) of the both-end voltage of an inverter with respect to the time after start of the discharge.

Meanwhile, WO 2004/088696 A discloses a method and an apparatus for detecting the welding of a relay contact. This detection method (or apparatus) performs sequence (turning on/off) control on first and second main relays and a precharge relay. The first and second main relays are provided in positive and negative power supply lines of a DC power supply. The precharge relay is provided in parallel with the contact of the first main relay and is configured by a resistor and a contact. In the sequence control, it is determined whether any one of the first and second main relays is welded by checking whether or not the both-end voltage of a load circuit decreases.

However, according to the technology disclosed in JP 2000-278802 A, when relay welding occurs, there is no change in the both-end voltage of the inverter, and accordingly, the occurrence of the relay welding itself can be identified but a welding-occurred relay would not be identified.

In contrast, according to the technology disclosed in WO 2004/088696 A, it can be determined which one of the first and second main relays is welded. However, in a case where the resistance value of the load circuit is much higher than the resistance value of the resistor (precharge resistor) of the precharge relay, the both-end voltage of the load circuit decreases in low speed, and accordingly, quick or rapid diagnosis would not be available.

For example, in a case where the resistance value of the load circuit (discharge resistor) is 160 kΩ while the resistance value of the precharge resistor is 300 Ω, it takes a time to perform discharge through the load circuit, and accordingly, the quick or rapid diagnosis would not be available. In other words, according to the technology disclosed in WO 2004/088696 A, the time required for the diagnosis depends on the ratio between the resistance values of the precharge resistor and the discharge resistor.

In addition, according to the technology disclosed in WO 2004/088696 A, it can be determined which main relay is welded, however, a detection of an abnormality of a circuit component (for example, an abnormality of the precharge resistor) is not available.

SUMMARY

It is an object in one aspect of the embodiment(s) to enable a quick or rapid detection of an abnormality of a relay circuit.

According to an aspect of the embodiment(s), there is provided a diagnosis apparatus for a relay circuit. The relay circuit includes: a load circuit supplied with a direct-current (DC) voltage from a direct-current (DC) power supply; a capacitor connected to both ends of the load circuit; a first main relay provided for a power supply line between a positive terminal of the DC power supply and one end of the load circuit; a second main relay provided for a power supply line between a negative terminal of the DC power supply and the other end of the load circuit; a series circuit of a first resistor and a precharge relay that are provided in parallel with the second main relay; and a second resistor connected to both ends of the load circuit. The diagnosis apparatus includes: a voltage sensor configured to detect a both-end voltage of the capacitor; a relay controller configured to performs an on-off control on each of the relays in accordance with a predetermined sequence; and a determiner configured to detect an abnormality of the first resistor based on the voltage detected by the voltage sensor and an equivalent resistance value representing a discharge process in a sequence including the discharge process, the discharge process being performed by the relay controller to turn on both of the first main relay and the precharge relay and turn off the second main relay to apply a reactive current with an amount indicated by a value stored in a memory to the load circuit.

According to the technology described above, an abnormality of the resistor of the relay circuit can be detected quickly or rapidly.

BRIEF DESCRIPTION OF DRAWINGS

FIG. 1 is a block diagram illustrating an example of the configuration of a vehicle according to a first embodiment focusing on a motor driving system;

FIG. 2 is a diagram illustrating an example of the state of Sequence #1 in the configuration illustrated in FIG. 1;

FIG. 3 is a diagram illustrating an example of the state of Sequence #2 in the configuration illustrated in FIG. 1;

FIG. 4 is a diagram illustrating an example of the state of Sequence #3 in the configuration illustrated in FIG. 1;

FIG. 5 is a graph illustrating an example of a change in a discharge resistance value with respect to a discharge current value;

FIG. 6 is a diagram illustrating an example of the state of Sequence #4 in the configuration illustrated in FIG. 1;

FIG. 7 is a diagram illustrating an example of the state of Sequence #5 in the configuration illustrated in FIG. 1;

FIG. 8 is a diagram illustrating an example of the state of Sequence #6 in the configuration illustrated in FIG. 1;

FIG. 9 is a diagram illustrating examples of a change in the both-end voltage (C voltage) of a capacitor C with respect to time, a change in the on-off state of each relay, and a change in a discharge current amount in Sequences #1 to #6;

FIG. 10 is a diagram illustrating examples of a change in the both-end voltage (C voltage) of the capacitor C with respect to time, a change in the on-off state of each relay, and a change in the discharge current amount in Sequences #1 to #6;

FIG. 11 is a diagram illustrating examples of a change in the both-end voltage (C voltage) of the capacitor C with respect to time, a change in the on-off state of each relay, and a change in the discharge current amount in a case where a precharge relay is welded before the start of Sequences #1 to #6;

FIG. 12 is a flowchart illustrating Sequences #1 to #5 according to the first embodiment;

FIG. 13 is a flowchart illustrating Sequences #5 and #6 according to the first embodiment;

FIG. 14 is a flowchart illustrating Sequences #1 to #5 according to a second embodiment;

FIG. 15 is a flowchart illustrating Sequences #5 and #6 according to the second embodiment;

FIG. 16 is a diagram illustrating examples of a change in the both-end voltage (C voltage) of a capacitor C with respect to time, a change in the on-off state of each relay, and a change in a discharge current amount in Sequences #1 to #6 according to the second embodiment;

FIG. 17 is a diagram illustrating examples of a change in the both-end voltage (C voltage) of the capacitor C with respect to time, a change in the on-off state of each relay, and a change in the discharge current amount in a case where a positive-side main relay is welded in the second embodiment;

FIG. 18 is a flowchart illustrating a third embodiment;

FIG. 19 is a flowchart illustrating Sequences #1 to #5 according to a fourth embodiment;

FIG. 20 is a flowchart illustrating Sequences #5 and #6 according to the fourth embodiment;

FIG. 21 is a diagram illustrating examples of a change in the both-end voltage (C voltage) of a capacitor C with respect to time, a change in the on-off state of each relay, and a change in a discharge current amount in Sequences #1 to #6 according to the fourth embodiment;

FIG. 22 is a flowchart illustrating Sequences #1 to #5 according to a fifth embodiment; and

FIG. 23 is a flowchart illustrating Sequences #5 and #6 according to the fifth embodiment.

DESCRIPTION OF EMBODIMENTS

Hereinafter, exemplary embodiments will be described with reference to the appended drawings. Here, the following embodiments are merely exemplary, and are not intended to exclude applications of various modifications or techniques which are not described below. In the drawings used in the following embodiments, the same components are denoted by the same reference numerals unless otherwise set forth.

(First Embodiment)

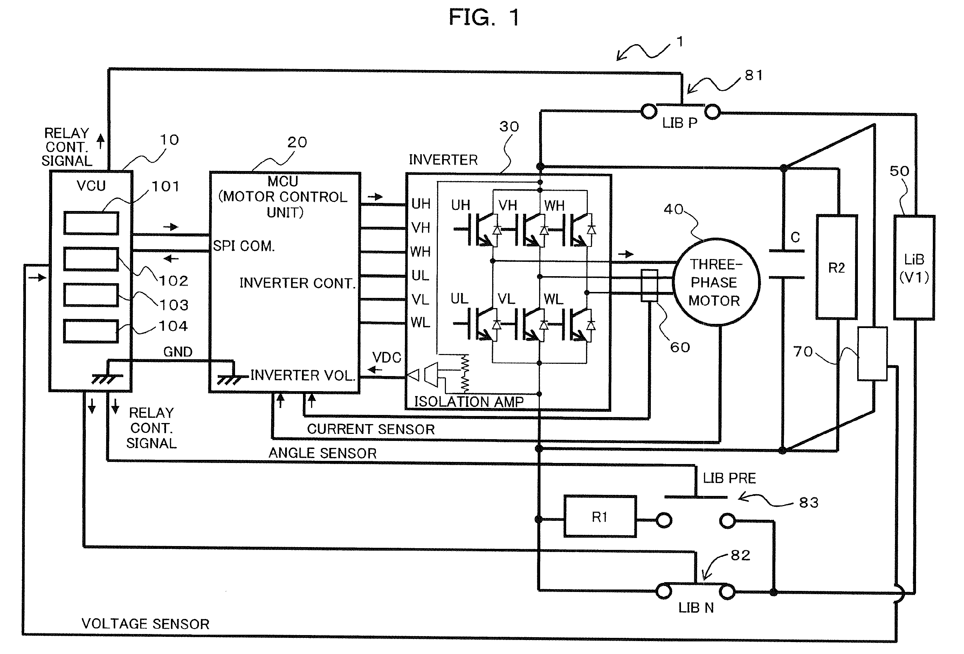

FIG. 1 is a block diagram illustrating an example of the configuration of a vehicle according to a first embodiment focusing on a motor driving system. For example, the motor drive system 1 illustrated in FIG. 1 is used in a next-generation vehicle such as an electric vehicle (EV) or a hybrid vehicle (HEV). The motor drive system 1, for example, includes a vehicle control unit (VCU) 10, a motor control unit (MCU) 20, an inverter 30, a three-phase motor 40, and a lithium ion battery (LiB) 50.

The VCU 10 controls the traveling of the vehicle by transmitting a drive control signal such as a torque instruction value to the MCU 20 based on an accelerator sensor signal and a brake sensor signal acquired by an accelerator sensor and a brake sensor not illustrated in the figure. For example, the VCU 10 performs an instruction for the calculation or regeneration of a drive torque based on the accelerator sensor signal, an instruction for the calculation of a regenerated energy amount based on the brake sensor signal, control of drivability, and the like.

The MCU 20 is communicably connected to the VCU 10 through a serial peripheral interface (SPI) or the like. The MCU 20 controls the inverter 30 based on a traveling control signal given from the VCU 10 through SPI communication, thereby drive power given to the three-phase motor 40 is controlled.

For example, the MCU 20 performs feedback control of the three-phase motor 40 based on a torque instruction value and sensor signals of an angle sensor (resolver) and a current sensor 60 provided in the three-phase motor 40 such that the torque of the three-phase motor 40 coincides with the torque instruction value given from the VCU 10.

The inverter 30 receives a power source voltage (battery voltage: V1) from the LiB 50, generates a drive voltage of the three-phase motor 40 in accordance with drive power control performed by the MCU 20, and supplies drive power to the three-phase motor 40 as the three-phase AC. For example, the inverter 30 is configured using an IGBT module in which a switching element such as an insulated gate bipolar transistor (IGBT) and a free wheel diode forms an anti-parallel connection.

As illustrated in FIG. 1, the inverter 30 includes, for example, three IGBT elements UH, VH, and WH forming upper arms of the U phase, the V phase, and the W phase and three IGBT elements UL, VL, and WL forming lower arms of the U phase, the V phase, and the W phase. The gate voltages of the six IGBT elements UH, VH, WH, UL, VL, and WL are individually controlled by the MCU 20, whereby the drive power of the three-phase AC given to the three-phase motor 40 is controlled.

In addition, the inverter 30 detects a battery voltage VDC received from the LiB 50 using an isolation amplifier and supplies the detected battery voltage VDC to the MCU 20 as an inverter voltage. The MCU 20 is operable to notify the VCU 10 of the inverter voltage, for example, through the SPI communication, and accordingly, the VCU 10, for example, is operable to detect (monitor) an abnormality of an inverter voltage.

A capacitor C and a resistor R2 are connected to both of positive and negative ends of the inverter 30 in parallel. The capacitor C is a smoothing capacitor and suppresses a variation of the input voltage input from the LiB 50 to the inverter 30. When both of a first main relay and a precharge relay are turned on, and a second main relay is turned off, a divided voltage ratio of the battery voltage V1 supplied from the LiB 50 is determined by the resistor R2 together with the resistor (precharge resistor) R1. This will be described later in detail.

The three-phase motor 40 is an example of a driving source of the vehicle and is provided with the resolver and the current sensor 60 described above. The inverter 30 and the three-phase motor 40 are examples of the load circuit.

The LiB 50 is an example of the DC power supply and, for example, applies a DC voltage of 200 V or higher (for example, 300 V or the like) to the inverter 30. A first main relay (LIB P) 81 is disposed in the power supply line between the positive terminal of the LiB 50 and one terminal of the inverter 30. Further, a second main relay (LIB N) 82 is disposed in the power supply line between the negative terminal of the LiB 50 and the other terminal of the inverter 30. When both of the main relays 81 and 82 are turned on, power is supplied from the LiB 50 to the inverter 30. On the other hand, when both of the main relays 81 and 82 are turned off, the LiB 50 is electrically disconnected from the inverter 30 and the three-phase motor 40.

Furthermore, a series circuit configured by a resistor (precharge resistor) R1 and a precharge relay (LIB PRE) 83 is connected to the second main relay 82 in parallel therewith. The precharge resistor R1 is an example of a first resistor and the aforementioned resistor R2 is an example of a second resistor. Upon controlling both of the main relays 81 and 82 turned on, the precharge relay 83 may be turned on. However, the precharge relay is turned on after the positive-side main relay 81 is turned on and before the negative-side main relay 82 is turned on. Thereby, a charge current charging the capacitor C flows through the resistor R1, and the capacitor C is gradually charged. Therefore, even when the negative-side main relay 82 is turned on, a large inrush current toward the capacitor C is not generated. Thus, it is possible to prevent one or both of the main relays 81 and 82 from being welded.

The LiB 50, the resistors R1 and R2, the capacitor C, and the relays 81 to 83 described above configure an example of a relay circuit.

The on-off control on each relay 81 to 83, for example, is performed in accordance with a control signal (relay control signal) provided from the VCU 10. In this embodiment, as will be described later, by performing an on-off control on each of the relays 81 to 83 in accordance with a predetermined switching sequence and monitoring a change in the both-end voltage V of the capacitor C in the switching sequence, it is possible to detect whether or not any one relay is welded. Further, by monitoring a change in the both-end voltage V, it is possible to detect an abnormality of the precharge resistor R1.

For this, a voltage sensor 70 that senses (detects) a voltage is connected to both ends of the capacitor C (resistor R2). A voltage detection result obtained by the voltage sensor 70, for example, is supplied to the VCU 10. The VCU 10 detects whether a relay is welded and whether there is an abnormality of the precharge resistor R1 based on the voltage detection result (in other words, a change in the both-end voltage of the capacitor C (the resistor R2)) during the aforementioned switching sequence.

For this, the VCU 10 includes, for example, a relay controller 101, a determiner 102, a memory 103, and a discharge controller 104. These units 101 to 104 configure an example of the diagnosis apparatus for a relay circuit together with the voltage sensor 70.

The relay controller 101 performs an on-off control on each of the relays 81 to 83 in accordance with a switching sequence represented in Table 1 set out below.

The amount of a reactive current to flow during discharging in the sequence may be stored in the memory 103. The memory 103 may be installed in the MCU 20. The relay controller 101 performs control so that a reactive current of an amount indicated by a value read from the memory 103 flows.

The amount of the reactive current stored in the memory 103 in advance, for example, may be determined based on values of the precharge resistor R1, the capacitor C, the LiB voltage, the determination time, and the discharge resistor $R_{dis}$. The amount of the reactive current may be stored in the memory 103 when the product is shipped.

In Embodiments 4 and 5 to be described later, the amount of the reactive current in Sequences # 1 to #4 and Sequences #5 and #6 may be changed. In such a case, the amount of the reactive current stored in the memory 103 may be read before start of the discharge in the sequence.

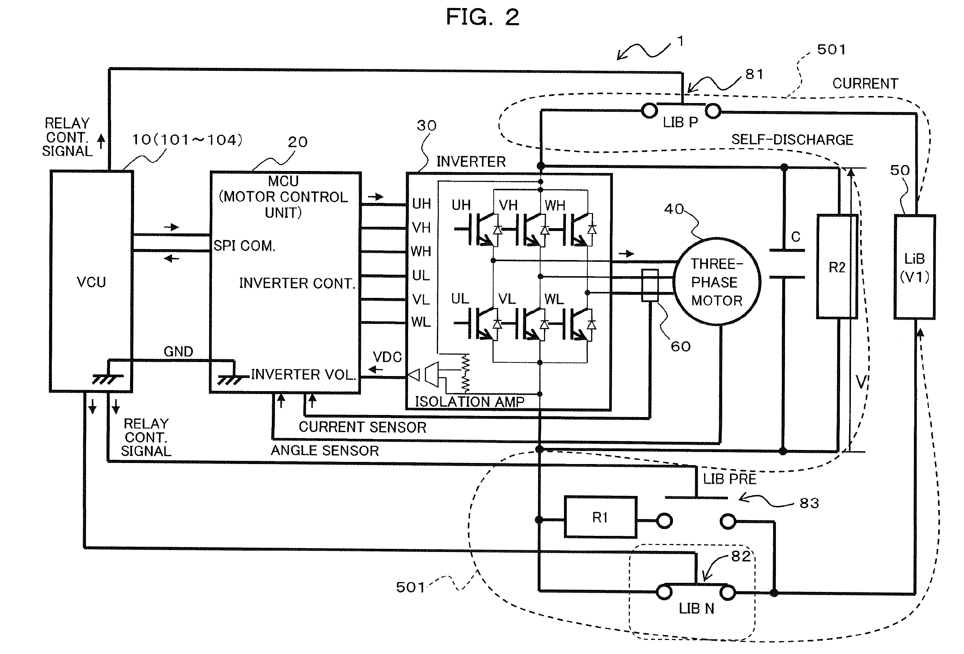

FIGS. 2 to 4 and 6 to 8 illustrate connection states of the relays 81 to 83 and current paths corresponding to Sequences #1 to #6. In FIGS. 2 to 4 and 6 to 8, the voltage sensor 70 is not illustrated.

[Table 1]

| Switching Sequence | | | | |
|---|---|---|---|---|
| Sequence No. | LIB PRE | LIB P | LIB N | Discharge |
| (Before Sequence) | OFF | ON | ON | No |
| 1 | OFF | ON | ON | No |
| 2 | OFF | ON | OFF | Yes |
| 3 | ON | ON | OFF | Yes |
| 4 | ON | OFF | OFF | Yes |
| 5 | ON | ON | OFF | Yes |
| 6 | OFF | ON | OFF | Yes |

In other words, before start of the sequence (before the inrush) and in Sequence #1, as illustrated in FIG. 2, the relay controller 101 controls both of the main relays 81 and 82 turned on and controls the precharge relay 83 turned off. In this case, the battery voltage is applied to both ends of the capacitor C (the resistor R2) from the LiB 50 (in other words, a voltage V detected by the voltage sensor 70 is V1), and self-discharge occurs in a path illustrated by a dotted-line arrow 501. In other words, a current flows in a path 501 starting from the LiB 50, passing through the positive-side main relay 81, the resistor R2, and the negative-side main relay 82, and returning to the LiB 50.

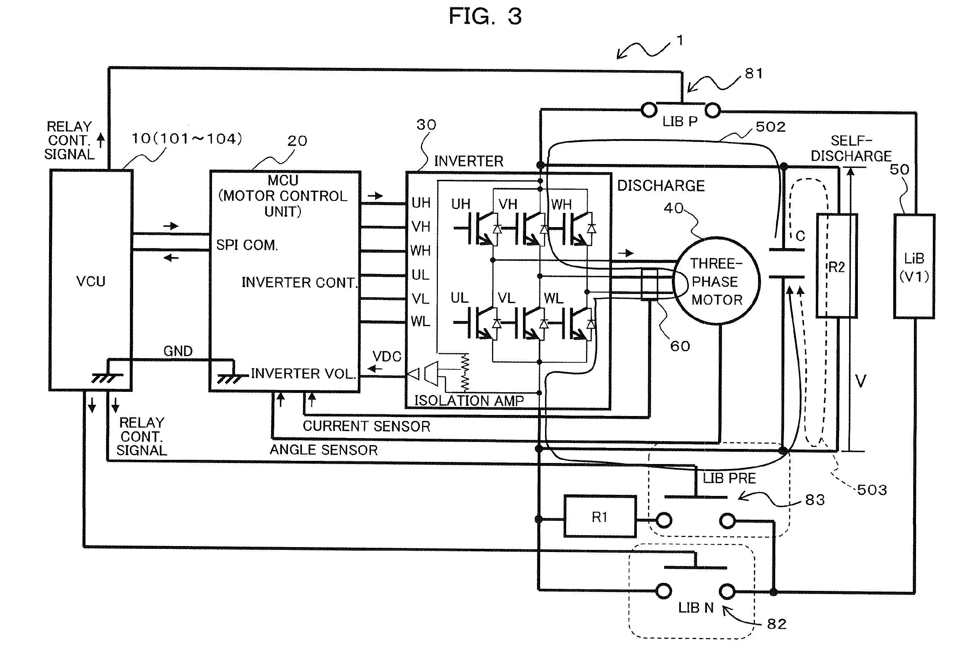

Thereafter, in Sequence #2, the relay controller 101, as illustrated in FIG. 3, controls the negative-side main relay 82 turned off. Further, the discharge controller 104 gives a discharge start instruction to the MCU 20. Thereby, the MCU 20 controls the IGBT element such that a reactive current flows into a d-axis of the three-phase motor 40 through the inverter 30.

In that case, a current flows in a path denoted by a solid-line arrow 502 in FIG. 3 (discharge). In other words, electric charge accumulated in the capacitor C flows from the positive side of the capacitor C to the d-axis of the three-phase motor 40 through the IGBT element configuring the upper arm of the inverter 30 (reactive current) and flows to the negative side of the capacitor C through the IGBT element configuring the lower arm of the inverter 30. Also, a part of the electric charge accumulated in the capacitor C flows to the resistor R2 in a path denoted by a dotted-line arrow 503 (self-discharge). The both-end voltage (in other words, a voltage detected by the voltage sensor 70) V of the capacitor (the resistor R2) at this time is decreased toward V = 0.

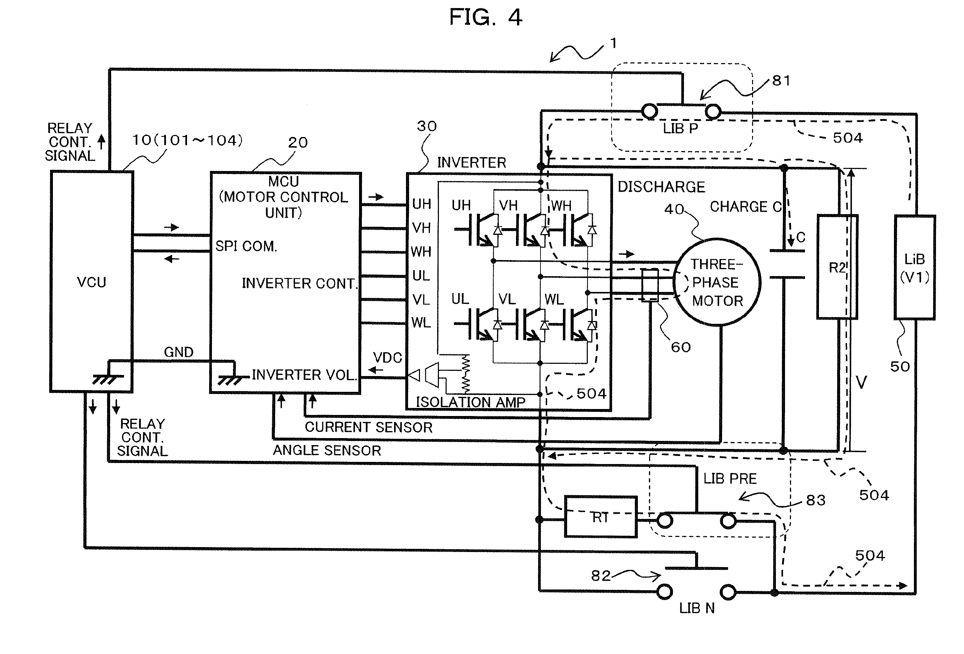

Thereafter, in Sequence #3, the relay controller 101, as illustrated in FIG. 4, controls the precharge relay 83 turned on. In that case, a current flows in a path illustrated by a dotted-line arrow 504 in FIG. 4. In other words, a current (discharge current) flows from the positive side of the LiB 50 to the negative side of the LiB 50 through the main relay 81, the inverter 30, the three-phase motor 40 (d axis), the precharge resistor R1, and the precharge relay 83. Further, a current flows from the positive side of the LiB 50 to the negative side of the LiB 50 through the main relay 81, the resistor R2, the precharge resistor R1, and the precharge relay 83. At this time, electric charge is accumulated (charged) in the capacitor C. In conclusion, the current flows to the d-axis of the three-phase motor 40 through the inverter 30, and the capacitor C is charged. The both-end voltage (in other words, a voltage detected by the voltage sensor 70) V of the capacitor C (the resistor R2) at this time is represented in the following Equation (1).

$$V = V1 \times \{(R_{dis} \cdot R2)/(R_{dis} + R2)\}/\{R1 + (R_{dis} \cdot R2)/(R_{dis} + R2)\} \quad \ldots (1)$$

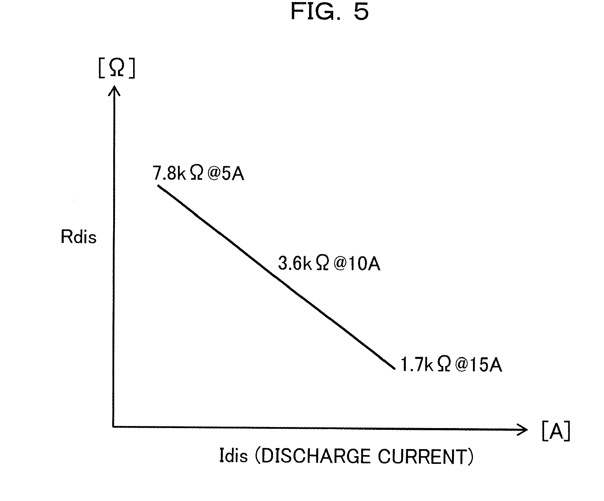

Here, R1 and R2 respectively represent resistance values of the resistors R1 and R2. For example, R1 is 300 Ω and R2 is 180 kΩ. $R_{dis}$ represents a resistance value in a case where the discharge is simulated as a resistor. For example, $R_{dis}$ can be represented as a variable resistance value which changes in the range of about 1 kΩ to 8 kΩ in a case where the discharge current $I_{dis}$ changes in the range of 5 to 15 A (ampere), as illustrated in FIG. 5. The reason for the decrease in the both-end voltage of the capacitor C due to discharge (in other words, a decrease in the energy collected in the capacitor C) is that energy is consumed as heat in accordance with heat dissipation of the coil of the three-phase motor 40 in a coil resistor due to conduction and heat dissipation due to conduction of the IGBT and the diode and switching. The effect of the consumption of energy as such heat is equivalently simulated as discharge according to the resistor $R_{dis}$. Further, since the amount of consumption as heat is proportional to the amount of the discharge current, $R_{dis}$ can be considered as a variable resistance value which is monotonously decreased in accordance with an increase in the discharge current (the amount of heat dissipation increases as the resistance value decreases).

Accordingly, in Sequence #3, the both-end voltage V of the capacitor C (the resistor R2) increases toward a value, which is represented in the above-described Equation (1), acquired by dividing the battery voltage V1 by the precharge resistance value R1 and the discharge resistance value $R_{dis}$.

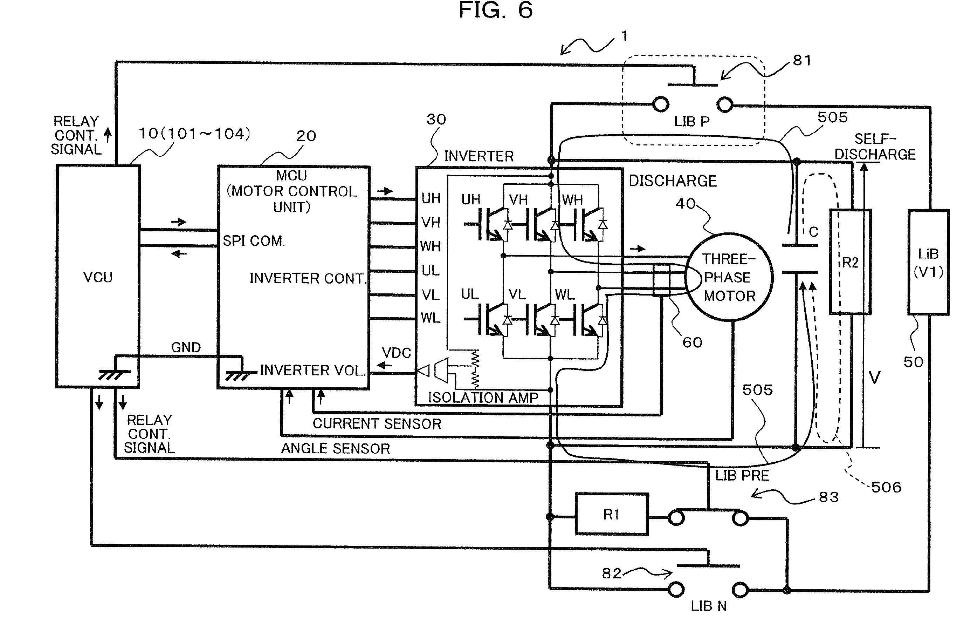

Next, in Sequence #4, the relay controller 101, as illustrated in FIG. 6, controls the positive-side main relay 81 turned off. In that case, a current flows in a path represented by a solid-line arrow 505 in FIG. 6 (discharge). In other words, electric charge accumulated in the capacitor C flows from the positive side of the capacitor C to the d-axis of the three-phase motor 40 through the IGBT element configuring the upper arm of the inverter 30 (reactive current) and flows to the negative side of the capacitor C through the IGBT element configuring the lower arm of the inverter 30. A part of the electric charge accumulated in the capacitor C also flows to the resistor R2 in a path denoted by a dotted-line arrow 506 (self-discharge). The both-end voltage (in other words, a voltage detected by the voltage sensor 70) V of the capacitor (the resistor R2) at this time is decreased toward V = 0.

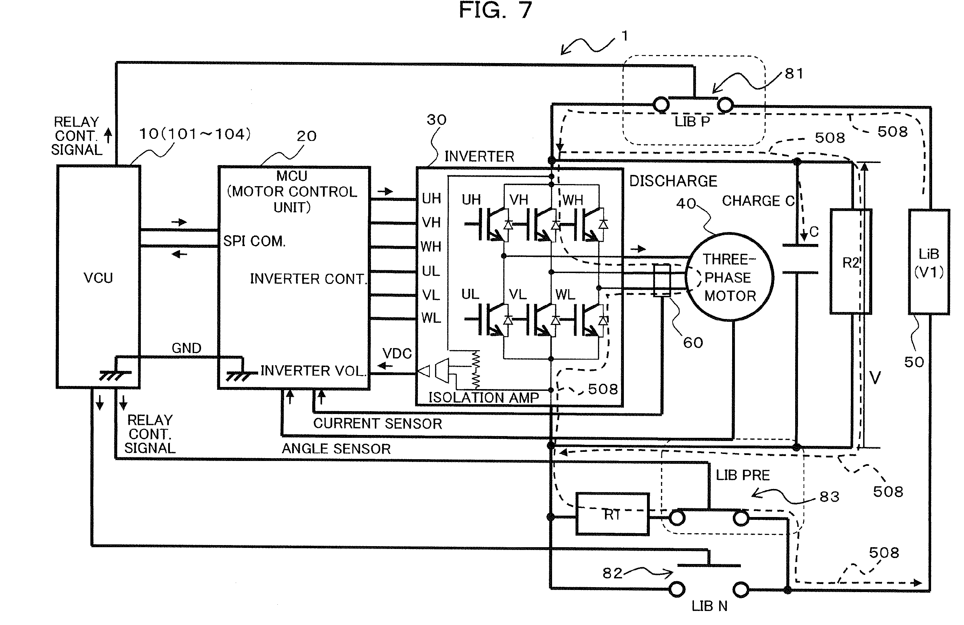

Thereafter, in Sequence #5, the relay controller 101, as illustrated in FIG. 7, controls the positive-side main relay 81 turned on. In that case, similar to the case of Sequence #3, a current flows in a path illustrated by a dotted-line arrow 508 in FIG. 7. In other words, the current flows to the d-axis of the three-phase motor 40 through the inverter 30, and the capacitor C is charged. The both-end voltage (in other words, a voltage detected by the voltage sensor 70) V of the capacitor C (the resistor R2) at this time is represented in Equation (1) described above.

Accordingly, in Sequence #5, the both-end voltage V of the capacitor C (the resistor R2) increases toward a value, which is represented in the above-described Equation (1), acquired by dividing the battery voltage V1 by the precharge resistance value R1 and the discharge resistance value $R_{dis}$.

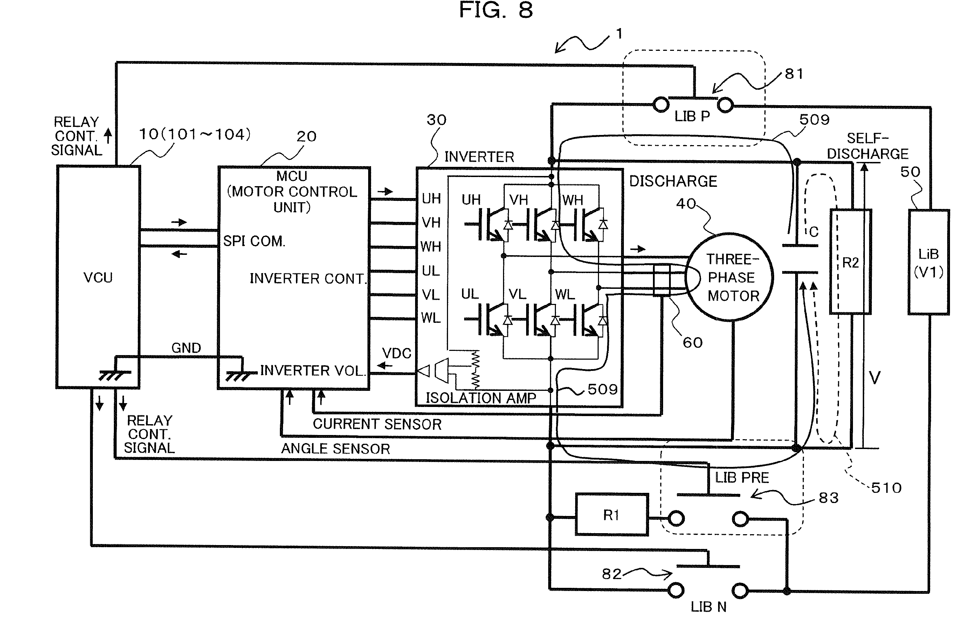

Next, in Sequence #6, the relay controller 101, as illustrated in FIG. 8, controls the precharge relay 83 turned off. In that case, similar to Sequence #2, a current flows in a path represented by a solid-line arrow 509 in FIG. 8 (discharge). In other words, electric charge accumulated in the capacitor C flows from the positive side of the capacitor C to the d-axis of the three-phase motor 40 through the IGBT element configuring the upper arm of the inverter 30 (reactive current) and flows to the negative side of the capacitor C through the IGBT element configuring the lower arm of the inverter 30. A part of the electric charge accumulated in the capacitor C also flows to the resistor R2 in a path denoted by a dotted-line arrow 510 (self-discharge). The both-end voltage (in other words, a voltage detected by the voltage sensor 70) V of the capacitor (the resistor R2) at this time is decreased toward V = 0.

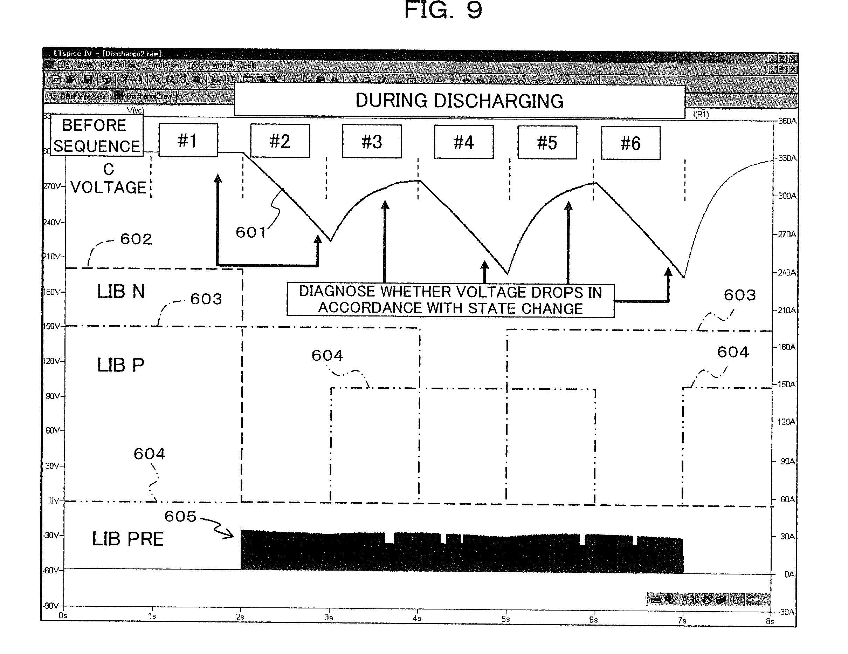

FIG. 9 illustrates examples of a change in the both-end voltage (C voltage) of the capacitor C with respect to time, a change in the on-off state of each of the relays 81 to 83, and a change in the discharge current amount in Sequences #1 to #6.

In FIG. 9, #1 to #6 represent periods corresponding to Sequences #1 to #6, respectively. Further, a solid line 601 represents a change in the C voltage, a dotted line 602 represents a change in the on-off state of the negative-side main relay 82, and a dashed line 603 represents a change in the on-off state of the positive-side main relay 81. Furthermore, a two-dot chain line 604 represents a change in the on-off state of the precharge relay 83, and reference numeral 605 represents a change in the amount of the discharge current during the discharge period (a period corresponding to Sequences #2 to #6).

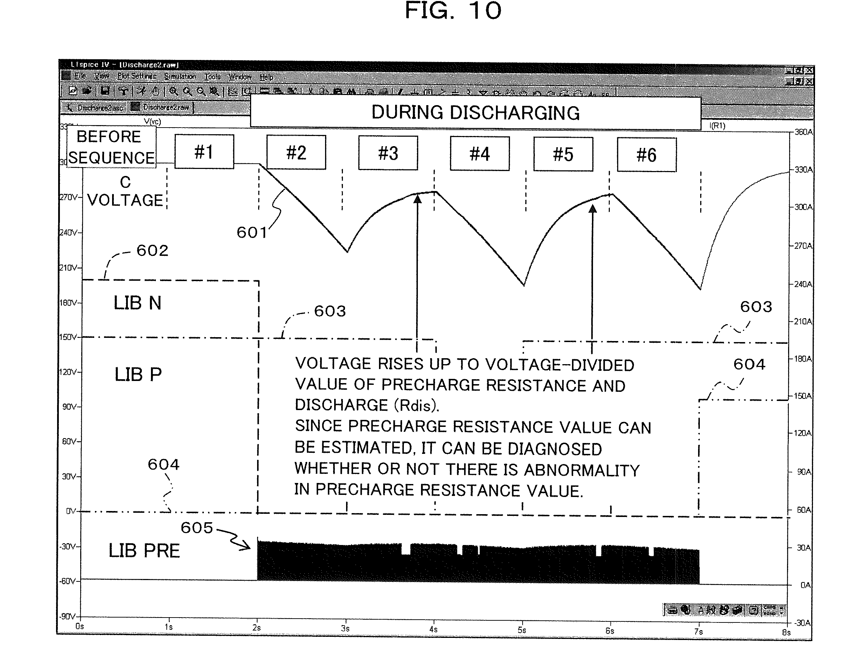

The VCU 10 is available to detect (diagnose) an abnormality of the battery voltage and whether any one of the relays 81 to 83 is welded by comparing the C voltage with a predetermined voltage threshold during the period corresponding to each of Sequences #1 to #6 by using the determiner 102. Further, as illustrated in FIG. 10, during the period corresponding to each of Sequences #3 to #5, the VCU 10 is also available to diagnose whether there is no abnormality of the precharge resistor R1 by comparing the C voltage with the predetermined voltage threshold by using the determiner 102.

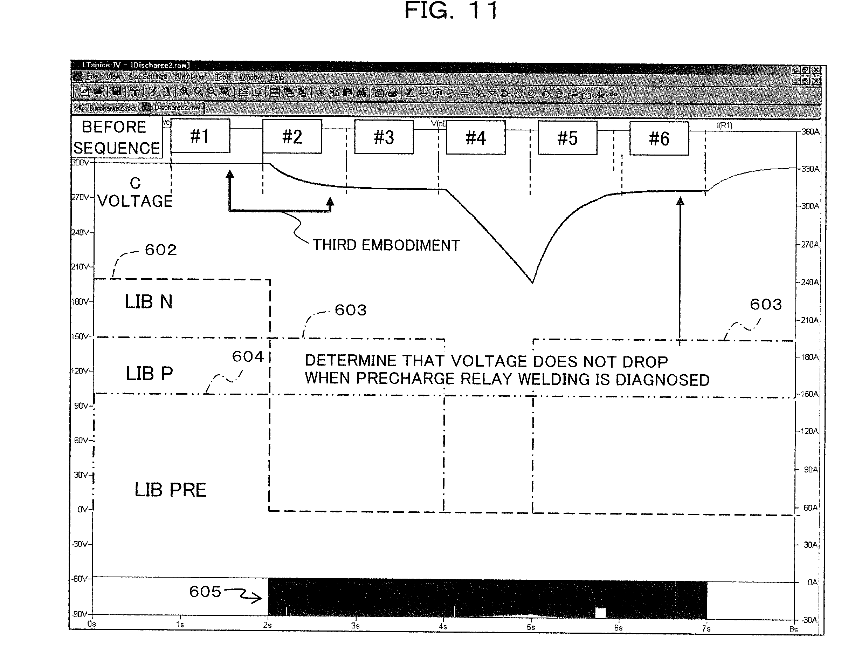

A case in which the precharge relay 83 has already been welded before the start of Sequences #1 to #6 may also be considered. In such a case, as illustrated in FIG. 11, the VCU 10 is available to diagnose whether or not the precharge relay 83 is welded by comparing the C voltage with a predetermined voltage threshold during the period corresponding to Sequence #6 by using the determiner 102. More specifically, it can be determined that the precharge relay 83 is welded in a case where the C voltage is not below the predetermined voltage threshold.

However, when the precharge relay 83 is welded, a voltage drop during the period corresponding to Sequence #2 is slow. Accordingly, by comparing a voltage drop value of the C voltage after the elapse of a predetermined time with a threshold, a welding diagnosis is available during the period corresponding to Sequence #2. This aspect will be described later in a third embodiment.

Each of the thresholds described above may be stored in, for example, the memory 103 and may be read by the determiner 102 appropriately.

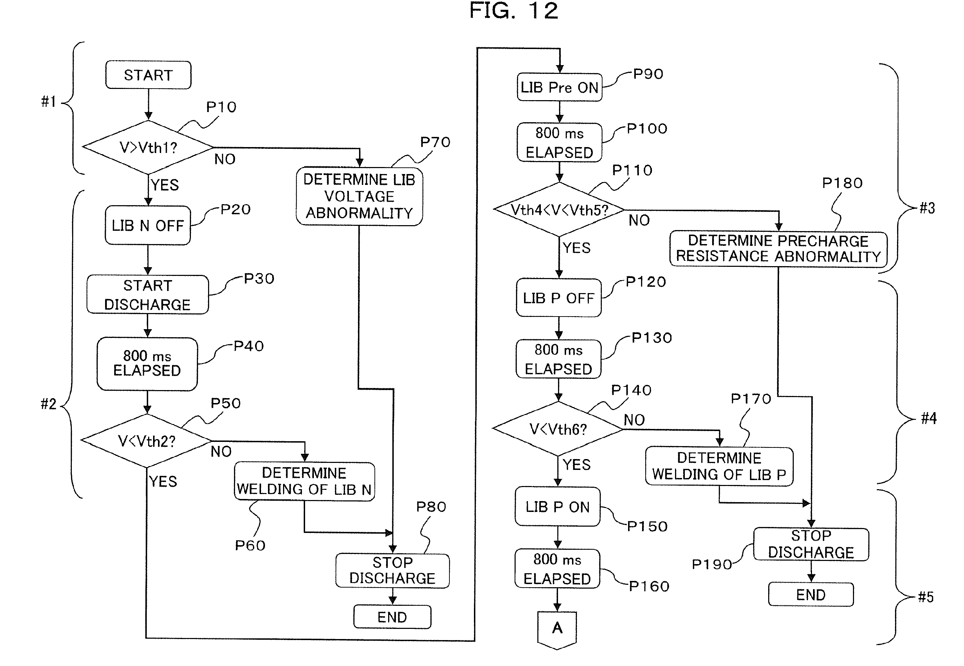

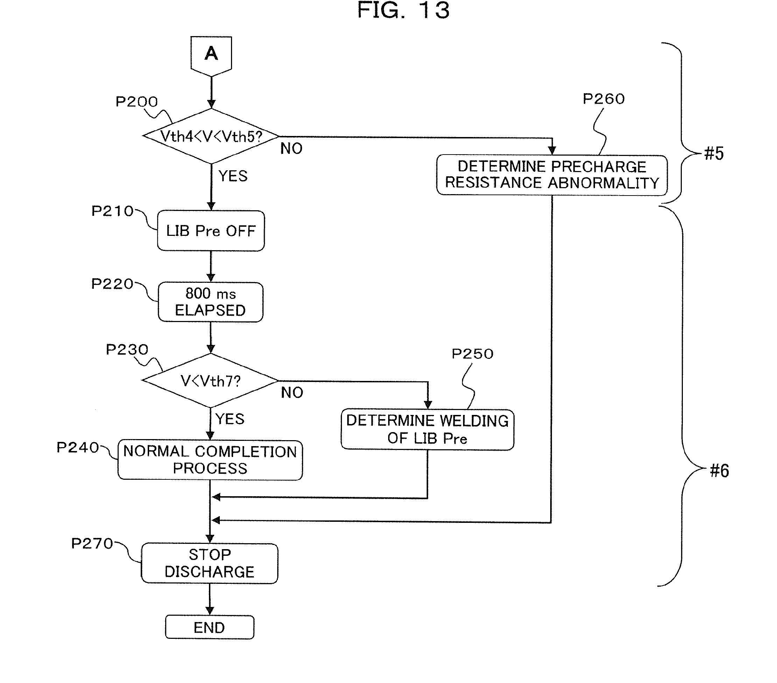

Hereinafter, a specific example of the above-described diagnosis will be described with reference to a flowchart illustrated in FIGS. 12 and 13. In FIGS. 12 and 13, #1 to #6 represent periods corresponding to Sequences #1 to #6, respectively.

First, as illustrated in FIG. 12, during the period corresponding to Sequence #1, the VCU 10 determines whether "V > Vth1" is satisfied by comparing the C voltage V detected by the voltage sensor 70 with a voltage threshold Vth1 using the determiner 102 (Process P10). For example, when the battery voltage V1 of the LiB 50 is 300 V, the voltage threshold Vth1 may be set to 290 V.

As a result, in a case where "V > Vth1" is not satisfied ("No" in Process P10), the determiner 102 determines that there is an abnormality of the battery voltage of the LiB 50 (Process P70). In this case, the VCU 10 (the relay controller 101) ends the process without performing subsequent Sequences #2 to #6 (discharge stop: Process P80).

On the other hand, in a case where V > Vth1 is satisfied ("Yes" in Process P10), the VCU 10 controls the negative-side main relay 82 turned off using the relay controller 101 (Process P20), and discharge is started by the discharge controller 104 (Process P30).

Thereafter, when a predetermined time (for example, 800 ms) elapses (Process P40), the VCU 10 determines whether V < Vth2 is satisfied by comparing the C voltage V detected by the voltage sensor 70 with a predetermined voltage threshold Vth2 (< Vth1) using the determiner 102 (Process P50). For example, in a case where the battery voltage V1 is 300 V, the voltage threshold Vth2 may be set to 250 V. Here, the predetermined time may be set in comprehensive consideration of the capacitance of the capacitor C, the discharge resistance value $R_{dis}$, a steady-state voltage value, switching control of the IGBT, the determination time, and the like (hereinafter, this similarly applies).

As a result, in a case where "V < Vth2" is not satisfied (in a case where the C voltage V is not below the voltage threshold Vth2: "No" in Process P50), the determiner 102 determines that the negative-side main relay 82 is welded (process P60). In such a case, the VCU 10 (the relay controller 101) stops discharge using the discharge controller 104 without performing subsequent Sequences #3 to #6 (Process P80) and ends the process.

On the other hand, in a case where "V < Vth2" is satisfied ("Yes" in Process P50), the VCU 10 controls the precharge relay 83 turned on using the relay controller 101 (Process P90). Thereafter, when a predetermined time (for example, 800 ms) elapses (Process P100), the VCU 10 determines whether "Vth4 < V < Vth5" is satisfied by comparing the C voltage V with predetermined voltage thresholds Vth4 and Vth5 by using the determiner 102 (Process P110). Here, for example, the voltage threshold Vth4 satisfies Vth2 < Vth4 < Vth1, and the voltage threshold Vth5 satisfies Vth4 < Vth5 < Vth1. For example, in a case where the battery voltage V1 is 300 V, the voltage thresholds Vth4 and Vth5 may be set to 265 V and 285 V, respectively.

As a result, in a case where "Vth4 < V < Vth5" is not satisfied ("No" in Process P110), the determiner 102 determines that there is an abnormality of the precharge resistor R1 (Process P180). In such a case, the VCU 10 (the relay controller 101) stops discharge by using the discharge controller 104 without performing subsequent Sequences #4 to #6 (Process P190) and ends the process.

On the other hand, in a case where "Vth4 < V < Vth5" is satisfied ("Yes" in Process P110), the VCU 10 controls the positive-side main relay 81 turned off by using the relay controller 101 (Process P120). Thereafter, when a predetermined time (for example, 800 ms) elapses (Process P130), the VCU 10 determines whether "V < Vth6" is satisfied by comparing the C voltage V with a predetermined voltage threshold Vth6 by using the determiner 102 (Process P140). Here, for example, the voltage threshold Vth6 satisfies Vth6 < Vth2. For example, in a case where the battery voltage V1 is 300 V, the voltage threshold Vth6 may be set to 230 V.

As a result, in a case where "V < Vth6" is not satisfied ("No" in Process P140), the determiner 102 determines that the positive-side main relay 81 is welded (process P170). In such a case, the VCU 10 (the relay controller 101) stops discharge by using the discharge controller 104 without performing subsequent Sequences #5 and #6 (Process P190) and ends the process.

On the other hand, in a case where "V < Vth6" is satisfied ("Yes" in Process P140), the VCU 10 controls the positive-side main relay 81 turned on by using the relay controller 101 (Process P150). Thereafter, when a predetermined time (for example, 800 ms) elapses (Process P160), as illustrated in FIG. 13, again, the determiner 102 determines whether "Vth4 < V < Vth5" is satisfied by comparing the C voltage V with the predetermined voltage thresholds Vth4 and Vth5 (Process P200).

As a result, in a case where "Vth4 < V < Vth5" is not satisfied ("No" in Process P200), the determiner 102 determines that there is an abnormality of the precharge resistor R1 (Process P260). In such a case, the VCU 10 (the relay controller 101) stops discharge by using the discharge controller 104 without performing the subsequent Sequence #6 (Process P270) and ends the process.

On the other hand, in a case where "Vth4 < V < Vth5" is satisfied ("Yes" in Process P200), the VCU 10 controls the precharge relay 83 turned off by using the relay controller 101 (Process P210). Thereafter, when a predetermined time (for example, 800 ms) elapses (Process P220), the VCU 10 determines whether "V < Vth7" is satisfied by comparing the C voltage V with a predetermined voltage threshold Vth7 by using the determiner 102 (Process P230). Here, for example, the voltage threshold Vth7 satisfies Vth7 < Vth2. For example, in a case where the battery voltage V1 is 300 V, the voltage threshold Vth7 may be set to 230 V. In other words, the voltage threshold Vth7 may be set to the same value as that of the voltage threshold Vth6 (= 230 V).

As a result, in a case where "V < Vth7" is not satisfied ("No" in Process P230), the determiner 102 determines that the precharge relay 83 is welded (process P250). In such a case, the VCU 10 stops discharge by using the discharge controller 104 (Process P270) and ends the process.

On the other hand, in a case where "V < Vth7" is satisfied ("Yes" in Process P230), a normal end process is performed (Process P240). For example, the discharge controller 104 stops the discharge (Process P270), and the process ends.

As described above, according to the aforementioned embodiment, the discharge process is controlled in which a reactive current of a reactive current amount corresponding to the value stored in the memory 103 is caused to flow in the load circuit. Accordingly, speedy discharge can be performed, whereby a quick or rapid diagnosis can be achieved. Further, in the sequence performing the discharge process, an abnormality of the precharge resistor R1 can be detected based on the both-end voltage of the capacitor C, which is detected by the voltage sensor 70, and the resistance value $R_{dis}$ that is an equivalent representation of the discharge process. Accordingly, the equivalent resistance value $R_{dis}$ can be freely set without depending on the resistance value of the precharge resistor R1 and the like.

In the first embodiment described above, the switching control of the relays 81 to 83 is performed in order of Sequences #1 to #6, however; the order of the sequences may be changed. For example, a set of Sequences #3 and #4 and a set of Sequences #5 and #6 may be interchanged in the execution order. Further, in a case where the precharge relay 83 is turned on in a stage before the start of the sequences, a set of Sequences #1 and #2 and a set of Sequences #3 and #4 (or a set of Sequences #5 and #6) may be interchanged in the execution order.

(Second Embodiment)

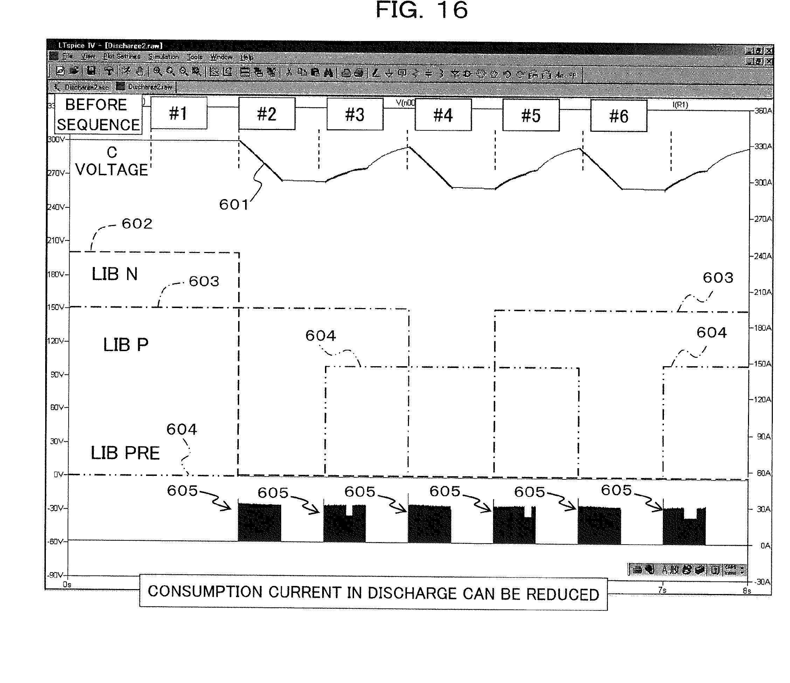

In the first embodiment described above, in the case of normal end, for example, as illustrated in FIG. 10, while discharge is continuously performed during the period corresponding to Sequences #2 to #6, for example. However, as denoted by reference numeral 605 in FIG. 16, inverter control may be performed such that discharge is intermittently performed by the discharge controller 104.

In such a case, the discharge controller 104 serves as an example of a discharge period controller that controls a period during which electric charge accumulated in the capacitor C or the electric charge supplied from the LiB 50 is discharged through the inverter 30 and the three-phase motor 40 for each sequence.

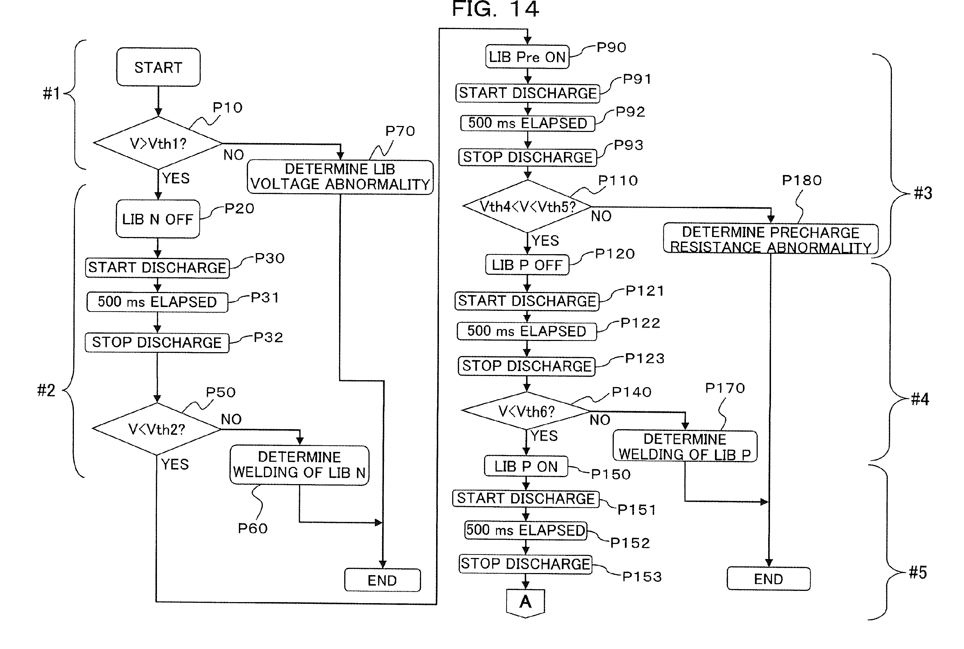

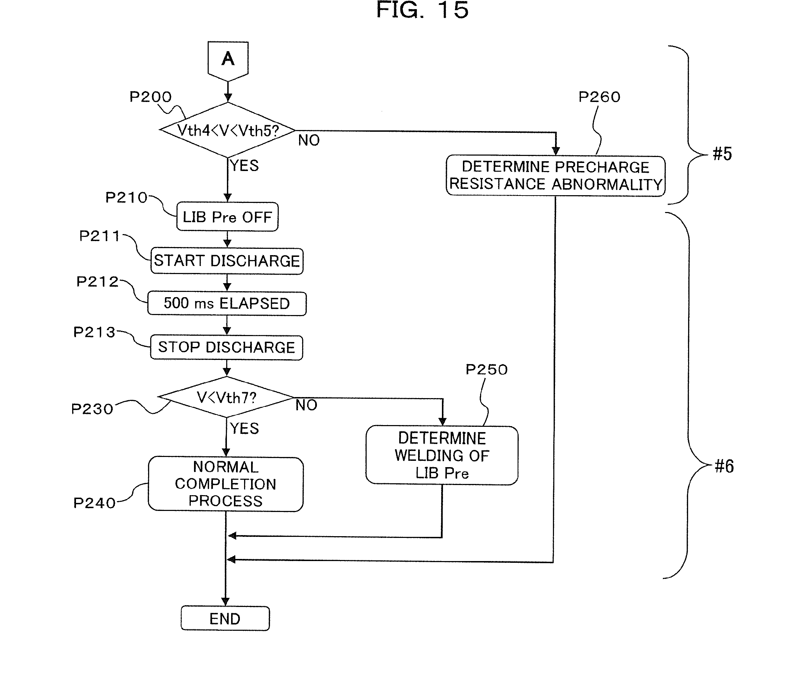

FIGS. 14 and 15 illustrate an example of the intermittent discharge operation. As can be understood by comparing FIGS. 14 and 15 and FIGS. 12 and 13 with each other, in the second embodiment, in each of Sequences #2 to #6, discharge is stopped when a predetermined time (for example, 500 ms) elapses from the start of discharge, which is different from the first embodiment.

For example, as illustrated in FIG. 14, in Sequence #2, after the negative-side main relay 82 is turned off (Process P20), discharge is started (Process P30), and, when a predetermined time elapses (Process P31), the discharge is stopped (Process P32).

Further, in Sequence #3, after the precharge relay 83 is turned on (Process P90), discharge is started (Process P91), and, when a predetermined time elapses (Process P92), the discharge is stopped (Process P93).

Furthermore, in Sequence #4, after the positive-side main relay 81 is turned off (Process P120), discharge is started (Process P121), and, when a predetermined time elapses (Process P122), the discharge is stopped (Process P123).

Further, in Sequence #5, after the positive-side main relay 81 is turned on (Process P150), discharge is started (Process P151), and, when a predetermined time elapses (Process P152), the discharge is stopped (Process P153).

Furthermore, as illustrated in FIG. 15, after the precharge relay 83 is turned off (Process P210), discharge is started (Process P211), and, when a predetermined time elapses (Process P212), the discharge is stopped (Process P213).

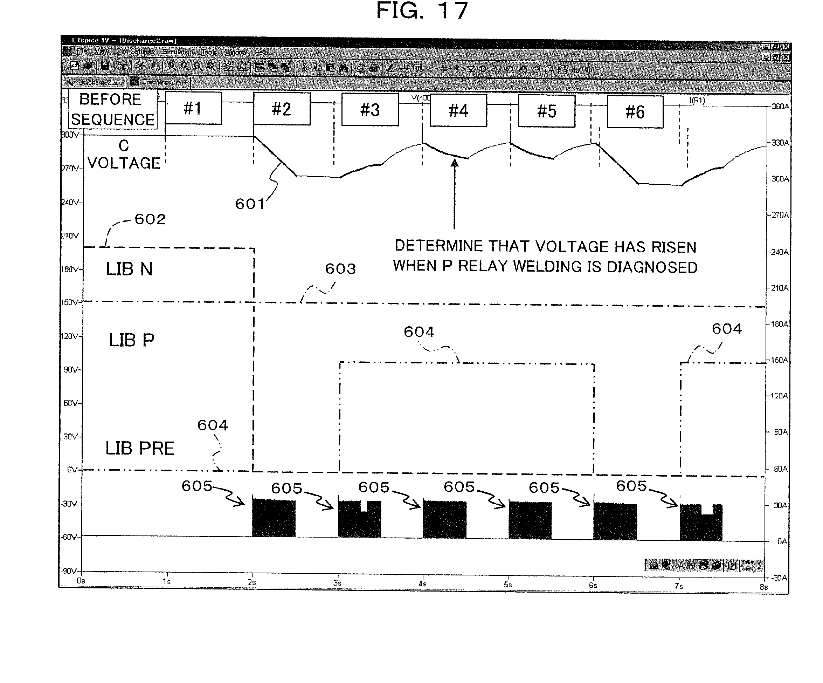

The other processes (the determination process and the like) to which the same reference numerals as those of the first embodiment (FIGS. 12 and 13) are depicted in FIGS. 14 and 15 are the same as those of the first embodiment. FIG. 16 illustrates an example of a change (see reference numeral 601) of the C voltage in a case where the above-described intermittent discharge is performed. FIG. 17 illustrates a case where the positive-side main relay 81 is determined as being welded because the C voltage is not below the predetermined voltage threshold Vth6 in Sequence #4.

As described above, during the period corresponding to Sequences #2 to #6, by intermittently performing discharge, the discharge period can be shorter than that of the first embodiment. Accordingly, the amount of the consumed current according to the discharge can be suppressed.

In the second embodiment described above, in each of the periods corresponding to Sequences #2 to #6, the start and the stop of discharge are performed, however; the start and the stop of discharge may be performed only for some of the periods.

(Third Embodiment)

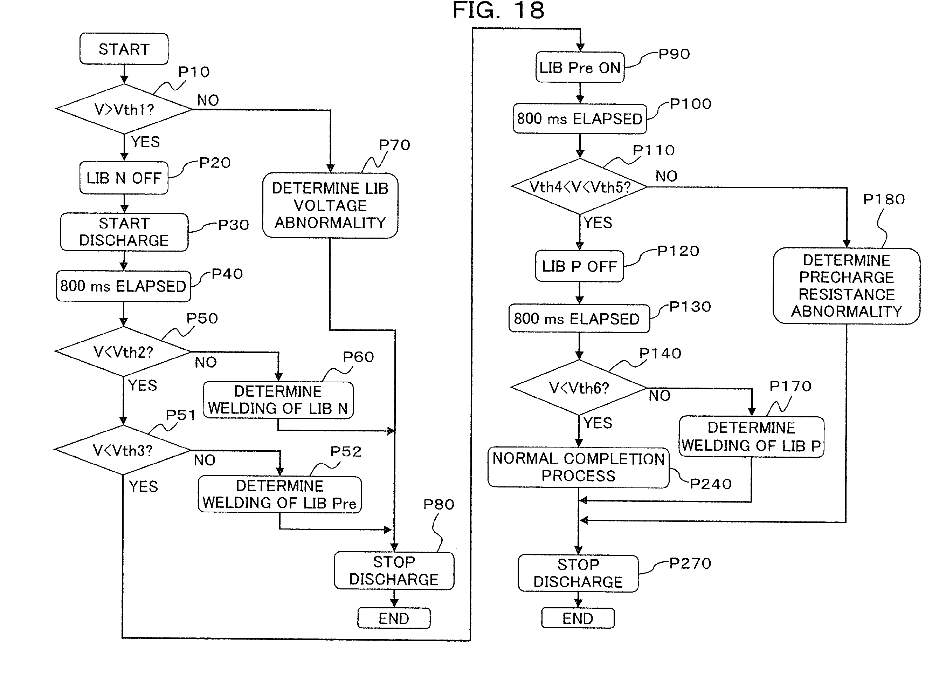

FIG. 18 illustrates an example of a flowchart of a relay welding diagnosis according to a third embodiment. The flowchart illustrated in FIG. 18 is different from the flowchart according to the first embodiment illustrated in FIGS. 12 and 13 in that Processes P51 and P52 are added. Further, in the case illustrated in FIG. 18, Processes P160, P190, P200, P210, P220, P230, and P250 illustrated in FIGS. 12 and 13 are unnecessary (deleted).

The reason for this is that, in Processes P51 and P52, in a case where the C voltage V is determined as not being below the predetermined threshold Vth3 by the determiner 102 ( "No" in Process P51), it can be determined that the precharge relay 83 is welded in Process P52. In a case where the precharge relay 83 is determined as being welded, the discharge is stopped by the discharge controller 104 (Process P80).

In a case where the C voltage V < Vth3 is satisfied ("Yes" in Process P51), Process P90 and subsequent processes illustrated in FIG. 18 are performed. For example, the determination of the abnormality of the precharge resistor R1 (Processes P110 and P180) and the determination of the welding of the positive-side main relay 81 (Processes P140 and P170) are performed. Here, the voltage threshold Vth3 satisfies "Vth3 < Vth2 < Vth1".

According to the third embodiment described above, the welding of the precharge relay 83 can be detected more quickly than that of each of the aforementioned embodiments.

(Fourth Embodiment)

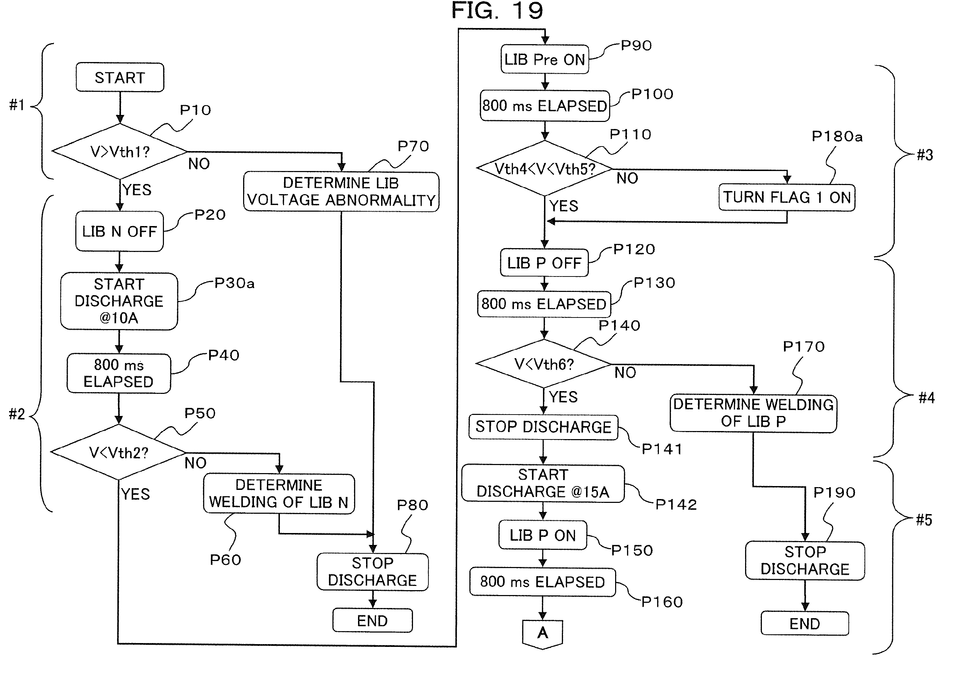

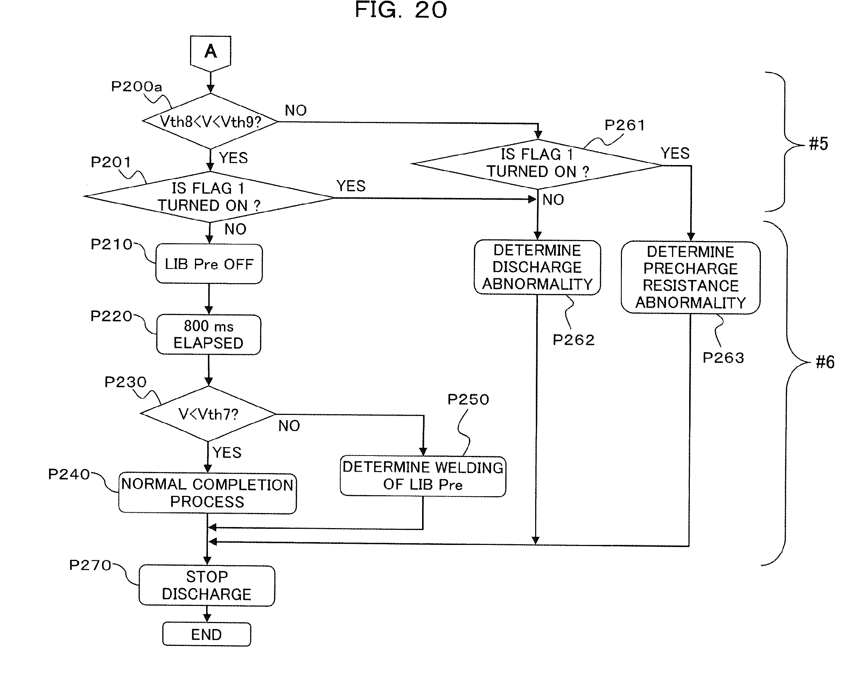

FIGS. 19 and 20 illustrate an example of the flow of a relay welding diagnosis according to a fourth embodiment. The flowchart illustrated in FIGS. 19 and 20 is different from the flowchart according to the first embodiment illustrated in FIGS. 12 and 13 in that the discharge current is controlled to different current values in Sequences #2 and #5. The control of the discharge current may be performed by the discharge controller 104.

The discharge controller 104 according to this embodiment is an example of a discharge current amount controller configured to control the amount of electric charge accumulated in the capacitor C or the electric charge supplied from the LiB 50 during the electric charge is discharged through the inverter 30 and the three-phase motor 40, for each sequence.

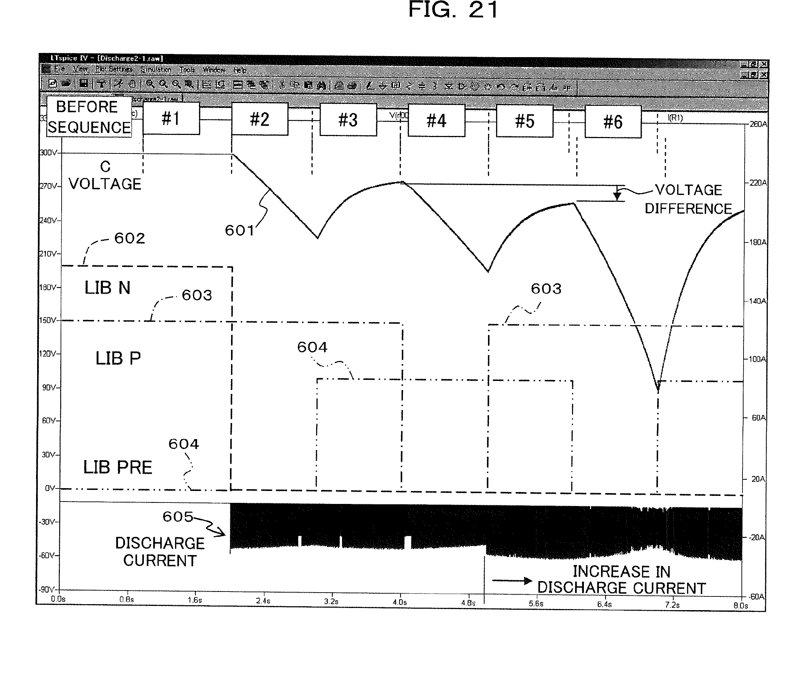

For example, in Sequence #2, after the negative-side main relay 82 is turned off (Process P20), discharge with 10 ampere (A) is started (Process P30a). On the other hand, in Sequence #5, after the C voltage V is determined as being below the voltage threshold Vth6 ("Yes" in Process P140), the discharge with 10A is stopped (Process P141), and discharge with 15 A is started (Process P142). Accordingly, as illustrated in FIG. 21, a discharge current increases to a value higher than that of the periods corresponding to Sequences #2 to #4.

As described above, by differentiating (changing) the discharge current, as illustrated in FIG. 21, there is a difference between C voltages of periods corresponding to Sequences #3 and #5. The determiner 102 can distinctively determine an abnormality of the precharge resistor R1 and an abnormality of the discharge based on the voltage difference.

For this, in a case where the C voltage V does not satisfy "Vth4 < V < Vth5" in process P110 (Sequence #3) illustrated in FIG. 19, the determiner 102 according to the fourth embodiment does not determine an abnormality of the resistor R2 in this stage but sets a "flag 1" to "On" (Process P180a). For example, "flag 1" is stored in the aforementioned memory 103.

Then, as illustrated in FIG. 20, after it is determined whether the C voltage V satisfies Vth8 < V < Vth9 in the subsequent Sequence #5 (Process P200a), the determiner 102 checks whether or not the "flag 1" is set to "On" (Processes P201 and P261). Here, voltage values Vth8 and Vth9, for example, satisfy "Vth8 < Vth9 < Vth4 < Vth5". As a non-limited example, in a case where the battery voltage V1 is 300 V, Vth8 and Vth9 may be set to 252 V and 267 V, respectively.

In a case where the C voltage V does not satisfy "Vth8 < V < Vth9", and the "flag 1" is set to "On" ( "No" in Process P200a and "Yes" in Process P261), the determiner 102 determines that there is an abnormality of the precharge resistor R1 (Process P263).

On the other hand, in a case where the C voltage V does not satisfy "Vth8 < V < Vth9", and the "flag 1" is set to "Off" ( "No" in Process P200a and "No" in Process P261), the determiner 102 determines that there is an abnormality of the discharge (Process P262). Further, in a case where the C voltage V satisfies "Vth8 < V < Vth9", and the "flag 1" is set to "On" ( "Yes" in Process P200a and "Yes" in Process P261), the determiner 102 determines that there is an abnormality of the discharge (Process P262).

As described above, according to the fourth embodiment, the amount of the discharge current during the discharge period is changed (differentiated). Thus, the determiner 102 can distinctively detect an abnormality of the precharge resistor R1 and an abnormality of the discharge based on a change in the C voltage between Sequences #3 and #5 in which current amounts are controlled to be mutually-different.

(Fifth Embodiment)

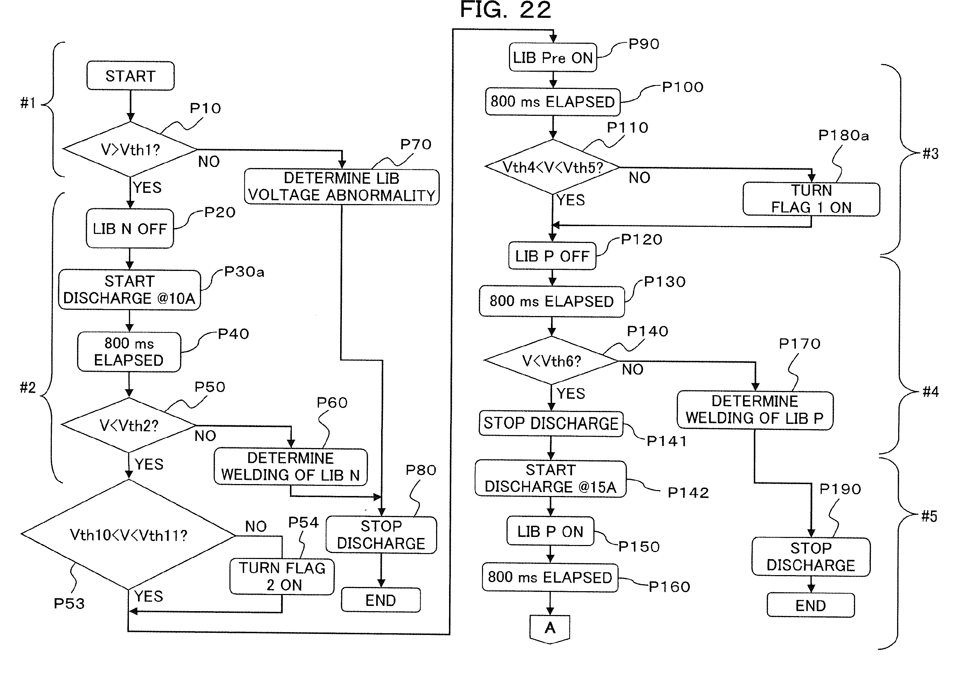

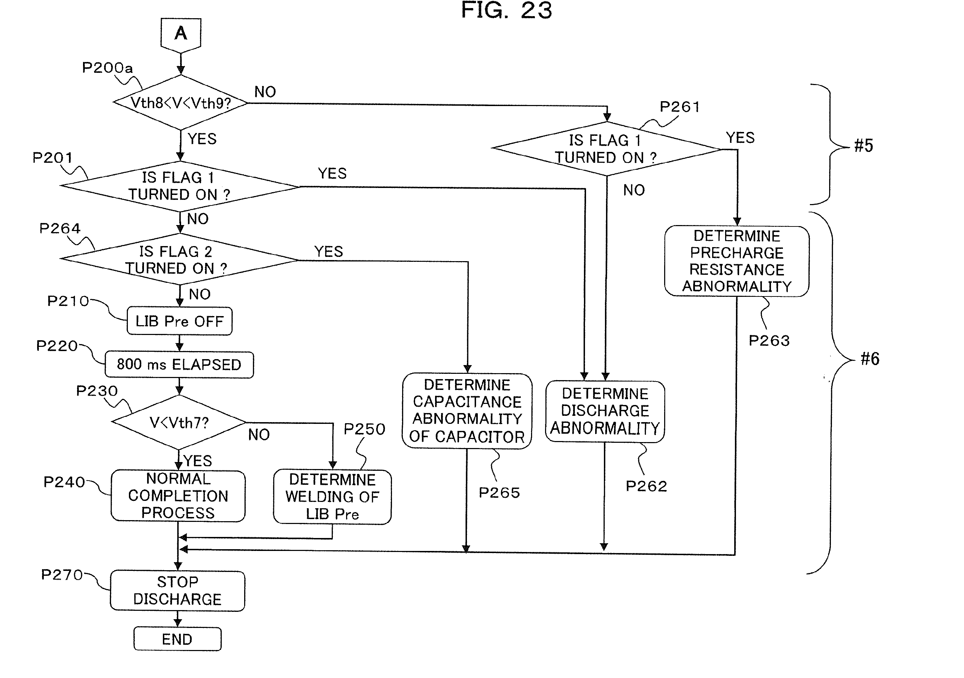

FIGS. 22 and 23 illustrate an example of the flow of a relay welding diagnosis according to a fifth embodiment. The flowchart illustrated in FIG. 22 is different from the flowchart according to the fourth embodiment illustrated in FIG. 19 in that Processes P53 and P54 are added. Further, the flowchart illustrated in FIG. 23 is different from the flowchart according to the fourth embodiment illustrated in FIG. 20 in that Processes P264 and P265 are added.

As illustrated in FIG. 22, in Process P53, in a case where the C voltage V is determined as being below the voltage threshold Vth2 ("Yes" in Process P50), the determiner 102 further determines whether the C voltage V drops to a voltage according to the resistance value $R_{dis}$ acquired by simulating the discharge as a resistor and the capacitance value of the capacitor C. For example, the determiner 102 determines whether or not the C voltage V satisfies "Vth10 < V < Vth11". Here, voltage thresholds Vth10 and Vth11, for example, may be set based on the following Equation (2) in consideration of the capacitance of the capacitor C, the resistance value $R_{dis}$, and a variation in the C voltage V. As a non-limited example, in a case where the battery voltage V1 is 300 V, Vth10 and Vth11 may be set to 230 V and 250 V, respectively.

$$V = V1 * [\exp\{-0.8/(C \cdot R_{dis})\}] \quad \ldots \quad (2)$$

In Equation (2), V1 represents the battery voltage of the Lib 50, and C represents the capacitance of the capacitor C.

As a result of the above-described determination, in a case where "Vth10 < V < Vth11" is satisfied (the C voltage V does not drop into a predetermined voltage range during discharge) ("No" in Process P53), the determiner 102 sets a "flag 2" to "On" (Process P54). The "flag 2" is stored in, for example, the memory 103.

On the other hand, as the result of the above-described determination, in a case where "Vth10 < V < Vth11" is satisfied ("Yes" in Process P53), the VCU 10, similar to the fourth embodiment, performs Process P90 and subsequent processes.

Next, as illustrated in FIG. 23, in Process P264, the determiner 102 determines whether or not the "flag 2" is set to "On". This determination is made in a case where the "flag 1" is set to "Off" (in the case of "No" in Process P201).

As a result of the determination made in Process P264, in a case where the "flag 2" is set to "On" (in the case of "Yes"), the determiner 102 determines that there is an abnormality of the capacitor C (Process P265). On the other hand, in a case where the "flag 2" is set to "Off" ("No" in Process P264), Processes P210, P22, P230, P240, P250 and P270 described above are performed.

As described above, according to the fifth embodiment, the same advantages as those of the fourth embodiment can be achieved, and additionally, by determining whether or not the C voltage satisfies "Vth10 < V < Vth11" during the discharge, a discharge abnormality and an abnormality of the capacitor C can be distinctively detected. Accordingly, an abnormality of the precharge resistor R1, an abnormality of the capacitor C, and a discharge abnormality can be detected individually.

According to the technology described above, an abnormality of the resistor of the relay circuit can be detected quickly or rapidly.

(Others)

The voltage thresholds used in each of the aforementioned embodiments may be determined in comprehensive consideration of the battery voltage V1 of the LiB 50, variations of components such as the resistor and the capacitor, a determination time, switching control of the IGBT, and the like. The voltage thresholds may be determined (set) as absolute values as described in each embodiment and may also be determined using a voltage value before the determination such as the battery voltage $V1 \times R_{dis}/(R_{dis} + R1) \pm 5\%$ (variation tolerance).

Further, in each of the embodiments described above, all of the relay controller 101, the determiner 102, the memory 103, and the discharge controller 104 are provided in the VCU 10. However, for example, a part of or all of the units 101 to 104 may be provided in the MCU 20. For example, by providing the relay controller 101 and the discharge controller 104 into the MCU 20, the communication amount using the SPI communication between the VCU 10 and the MCU 20, which is made during the discharge period or at the time of controlling the amount of the discharge current, can be suppressed.

Furthermore, in each of the embodiments described above, the motor driving system 1 (the diagnosis apparatus and the diagnosis method for a relay circuit) is applied to a vehicle such as an EV or a HEV, however; the motor driving system 1 may be generally applied to other ridable machines such as a train and a ship.

## Claims

**1.** A diagnosis apparatus for a relay circuit, the relay circuit comprising:

a load circuit (30 and 40) supplied with a direct-current (DC) voltage from a direct-current (DC) power supply (50);
a capacitor (C) connected to both ends of the load circuit (30 and 40);
a first main relay (81) provided for a power supply line between a positive terminal of the DC power supply (50) and one end of the load circuit (30 and 40);
a second main relay (82) provided for a power supply line between a negative terminal of the DC power supply (50) and the other end of the load circuit (30 and 40);
a series circuit of a first resistor (R1) and a precharge relay (83) that are provided in parallel with the second main relay (82); and
a second resistor (R2) connected to both ends of the load circuit (30 and 40),
the diagnosis apparatus comprising:

a voltage sensor (70) configured to detect a both-end voltage (V) of the capacitor (C);
a relay controller (101) configured to perform an on-off control on each of the relays (81 to 83) in accordance with a predetermined sequence; and
a determiner (102) configured to detect an abnormality of the first resistor (R1) based on the voltage (V) detected by the voltage sensor (70) and an equivalent resistance value ($R_{dis}$) representing a discharge process in a sequence including the discharge process, the discharge process being performed by the relay controller (101) to turn on both of the first main relay (81) and the precharge relay (83) and turn off the second main relay (82) to apply a reactive current with an amount indicated by a value stored in a memory (103) to the load circuit (30 and 40).

**2.** The diagnosis apparatus according to claim 1, wherein the determiner (102) determines whether any one of the relays (81 to 83) is welded based on a state change of the both-end voltage (V) in each of sequences performed by the relay controller (101), the sequences comprising:

a sequence turning off the second main relay (82) after a sequence turning on both of the main relays (81 and 82) and turning off the precharge relay (83);
a sequence turning off the first main relay (81) after turning on both of the precharge relay (83) and the first main relay (81) and turning off the second main relay (82);and
a sequence turning off the precharge relay (83) after turning on both of the precharge relay (83) and the first main relay (81) and turning off the second main relay (82).

**3.** The diagnosis apparatus according to claim 1 or 2, wherein the determiner (102) determines an abnormality of the first resistor (R1) in response to an out-of-range detection of the both-end voltage (V) from a predetermined voltage range during the sequence performed by the relay controller (101) to turn on both of the precharge relay (83) and the first main relay (81) and turn off the second main relay (82).

**4.** The diagnosis apparatus according to any one of claims 1 to 3, further comprising a discharge period controller (104) configured to control a period during which electric charge accumulated in the capacitor (C) or electric charge supplied from the DC power supply (50) is discharged through the load circuits (30 and 40) for each sequence.

**5.** The diagnosis apparatus according to any one of claims 1 to 3, further comprising a discharge current amount controller (104) configured to control the amount of discharge of electric charge accumulated in the capacitor (C) or electric charge supplied from the DC power supply (50) through the load circuits (30 and 40) for each sequence, wherein the determiner (102) distinguishes abnormalities of the first resistance (R1) and the discharge based on a change of the both-end voltage (V) between sequences controlled to mutually-different discharge current amounts by the discharge current amount controller (104).

**6.** The diagnosis apparatus according to claim 5, wherein the determiner (102) determines whether or not the both-end voltage drops to a voltage (V) according to a resistance value ($R_{dis}$) numerically-modeling the discharge as a resistance and the capacitance value of the capacitor (C) during the discharge to detect an abnormality of a capacitance value of the capacitor (C) .

**7.** A method of diagnosing a relay circuit, the relay circuit comprising: a load circuit (30 and 40) supplied with a direct-current (DC) voltage from a direct-current (DC) power supply (50); a capacitor (C) connected to both ends of the load circuit (30 and 40); a first main relay (81) provided for a power supply line between a positive terminal of the DC power supply (50) and one end of the load circuit (30 and 40); a second main relay (82) provided for a power supply line between a negative terminal of the DC power supply (50) and the other end of the load circuit (30 and 40); a series circuit of a first resistor (R1) and a precharge relay (83) that are provided in parallel with the second main relay (82); and a second resistor (r2) connected to both ends of the load circuit (30 and 40), the method comprising:

performing a discharge process to turn on both of the first main relay (81) and the precharge relay (83) and turn off the second main relay (82) to apply a reactive current with an amount indicated by a value stored in a memory (103) to the load circuit (30 and 40); and
detecting, in the discharge process, an abnormality of the first resistor (R1) based on a both-end voltage (V) of the capacitor (C) detected by a voltage sensor (70) and an equivalent resistance value ($R_{dis}$) representing the discharge process.

FIG. 1
1
81
LIB P
RELAY
CONT.
SIGNAL
10
VCU
101
102
103
104
GND
20
MCU
(MOTOR CONTROL
UNIT)
SPI COM.
INVERTER CONT.
INVERTER VOL.
VDC
30
INVERTER
UH
VH
WH
UL
VL
WL
ISOLATION AMP
40
THREE-
PHASE
MOTOR
60
C
R2
70
50
LiB
(V1)
RELAY
CONT.
SIGNAL
CURRENT SENSOR
ANGLE SENSOR
LIB PRE
83
R1
82
LIB N
VOLTAGE SENSOR

FIG. 2

1
501
CURRENT
81
LIB P
SELF-DISCHARGE
RELAY CONT. SIGNAL
10(101~104)
20
30
INVERTER
50
VCU
MCU (MOTOR CONTROL UNIT)
SPI COM.
INVERTER CONT.
UH
VH
WH
UL
VL
WL
40
THREE-PHASE MOTOR
C
R2
LiB (V1)
60
GND
INVERTER VOL.
VDC
ISOLATION AMP
V
RELAY CONT. SIGNAL
CURRENT SENSOR
ANGLE SENSOR
LIB PRE
83
R1
82
501
LIB N

FIG. 3
1
81
LIB P
502
RELAY
CONT.
SIGNAL
10(101~104)
20
30
INVERTER
SELF-
DISCHARGE
50
MCU
(MOTOR CONTROL
UNIT)
DISCHARGE
UH
VH
WH
40
C
SPI COM.
THREE-
PHASE
MOTOR
R2
LiB
(V1)
VCU
INVERTER CONT.
UL
VL
WL
60
GND
VDC
INVERTER VOL.
V
ISOLATION AMP
RELAY
CONT.
SIGNAL
CURRENT SENSOR
ANGLE SENSOR
LIB PRE
503
83
R1
LIB N
82

FIG. 4
1
81
LIB P
504
RELAY
CONT.
SIGNAL
10(101~104)
20
MCU
(MOTOR CONTROL
UNIT)
SPI COM.
INVERTER CONT.
INVERTER VOL.
GND
VCU
30
INVERTER
UH
VH
WH
UL
VL
WL
VDC
ISOLATION AMP
DISCHARGE
40
CHARGE C
C
THREE-
PHASE
MOTOR
60
R2
LiB
(V1)
50
V
CURRENT SENSOR
ANGLE SENSOR
LIB PRE
83
RT
82
LIB N

FIG. 5

7.8kΩ@5A
3.6kΩ@10A
1.7kΩ@15A
[A]
Idis (DISCHARGE CURRENT)
[Ω]
Rdis

FIG. 6

1
81
LIB P
RELAY CONT. SIGNAL
10(101~104)
20
30
INVERTER
505
SELF-DISCHARGE
MCU (MOTOR CONTROL UNIT)
DISCHARGE
UH
VH
WH
UH
VH
WH
40
SPI COM.
C
R2
LiB (V1)
THREE-PHASE MOTOR
VCU
INVERTER CONT.
UL
VL
WL
UL
VL
WL
60
50
GND
VDC
INVERTER VOL.
V
ISOLATION AMP
505
RELAY CONT. SIGNAL
CURRENT SENSOR
ANGLE SENSOR
LIB PRE
83
506
R1
82
LIB N

FIG. 7

1
81
LIB P
508
508
RELAY
CONT.
SIGNAL
10(101~104)
20
30
INVERTER
MCU
(MOTOR CONTROL
UNIT)
SPI COM.
INVERTER CONT.
VCU
UH
VH
WH
UL
VL
WL
DISCHARGE
CHARGE C
40
C
THREE-
PHASE
MOTOR
R2'
LiB
(V1)
60
50
V
GND
VDC
INVERTER VOL.
ISOLATION AMP
508
RELAY
CONT.
SIGNAL
CURRENT SENSOR
ANGLE SENSOR
LIB PRE
83
508
RT
508
82
LIB N

FIG. 8
1
81
LIB P
509
SELF-DISCHARGE
50
RELAY CONT. SIGNAL
10(101~104)
20
30
INVERTER
MCU (MOTOR CONTROL UNIT)
DISCHARGE
40
UH
VH
WH
UL
VL
WL
SPI COM.
INVERTER CONT.
VCU
C
R2
LiB (V1)
THREE-PHASE MOTOR
60
GND
VDC
INVERTER VOL.
509
ISOLATION AMP
V
RELAY CONT. SIGNAL
CURRENT SENSOR
ANGLE SENSOR
LIB PRE
510
83
R1
82
LIB N

FIG. 9

BEFORE SEQUENCE
DURING DISCHARGING
#1
#2
#3
#4
#5
#6
C VOLTAGE
LIB N
LIB P
LIB PRE
DIAGNOSE WHETHER VOLTAGE DROPS IN ACCORDANCE WITH STATE CHANGE
601
602
603
604
605
V(vc)
I(R1)

FIG. 10

BEFORE SEQUENCE
DURING DISCHARGING
#1
#2
#3
#4
#5
#6
C VOLTAGE
601
602
603
604
605
LIB N
LIB P
LIB PRE
VOLTAGE RISES UP TO VOLTAGE-DIVIDED VALUE OF PRECHARGE RESISTANCE AND DISCHARGE (Rdis).
SINCE PRECHARGE RESISTANCE VALUE CAN BE ESTIMATED, IT CAN BE DIAGNOSED WHETHER OR NOT THERE IS ABNORMALITY IN PRECHARGE RESISTANCE VALUE.
V(vc)
I(R1)
270V
240V
210V
180V
150V
120V
90V
60V
30V
0V
-30V
-60V
-90V
360A
330A
300A
270A
240A
210A
180A
150A
120A
90A
60A
30A
0A
-30A
0s
1s
2s
3s
4s
5s
6s
7s
8s

FIG. 11

BEFORE SEQUENCE
C VOLTAGE
#1
#2
#3
#4
#5
#6
THIRD EMBODIMENT
602
603
604
605
LIB N
LIB P
LIB PRE
DETERMINE THAT VOLTAGE DOES NOT DROP WHEN PRECHARGE RELAY WELDING IS DIAGNOSED
V(n
I(R1)
300V
270V
240V
210V
180V
150V
120V
90V
60V
30V
0V
-30V
-60V
-90V
360A
330A
300A
270A
240A
210A
180A
150A
120A
90A
60A
30A
0A
-30A
0s
1s
2s
3s
4s
5s
6s
7s
8s

FIG. 12

START
V>Vth1?
P10
YES
NO
LIB N OFF
P20
START DISCHARGE
P30
800 ms ELAPSED
P40
V<Vth2?
P50
YES
NO
DETERMINE WELDING OF LIB N
P60
DETERMINE LIB VOLTAGE ABNORMALITY
P70
STOP DISCHARGE
P80
END
LIB Pre ON
P90
800 ms ELAPSED
P100
Vth4<V<Vth5?
P110
YES
NO
LIB P OFF
P120
800 ms ELAPSED
P130
V<Vth6?
P140
YES
NO
LIB P ON
P150
800 ms ELAPSED
P160
A
DETERMINE PRECHARGE RESISTANCE ABNORMALITY
P180
DETERMINE WELDING OF LIB P
P170
STOP DISCHARGE
P190
END
#1
#2
#3
#4
#5

FIG. 13
A
P200
Vth4<V<Vth5?
YES
NO
P210
LIB Pre OFF
P220
800 ms ELAPSED
P230
V<Vth7?
YES
NO
P240
NORMAL COMPLETION PROCESS
P250
DETERMINE WELDING OF LIB Pre
P260
DETERMINE PRECHARGE RESISTANCE ABNORMALITY
P270
STOP DISCHARGE
END
#5
#6

FIG. 14

#1
START
V>Vth1?
P10
NO
YES
DETERMINE LIB VOLTAGE ABNORMALITY
P70
#2
LIB N OFF
P20
START DISCHARGE
P30
500 ms ELAPSED
P31
STOP DISCHARGE
P32
V<Vth2?
P50
NO
YES
DETERMINE WELDING OF LIB N
P60
END
LIB Pre ON
P90
START DISCHARGE
P91
500 ms ELAPSED
P92
STOP DISCHARGE
P93
Vth4<V<Vth5?
P110
NO
YES
DETERMINE PRECHARGE RESISTANCE ABNORMALITY
P180
#3
LIB P OFF
P120
START DISCHARGE
P121
500 ms ELAPSED
P122
STOP DISCHARGE
P123
V<Vth6?
P140
NO
YES
DETERMINE WELDING OF LIB P
P170
#4
LIB P ON
P150
START DISCHARGE
P151
500 ms ELAPSED
P152
STOP DISCHARGE
P153
A
END
#5

FIG. 15
A
P200
Vth4<V<Vth5?
YES
NO
P210
LIB Pre OFF
P211
START DISCHARGE
P212
500 ms ELAPSED
P213
STOP DISCHARGE
P230
V<Vth7?
YES
NO
P240
NORMAL COMPLETION PROCESS
P250
DETERMINE WELDING OF LIB Pre
P260
DETERMINE PRECHARGE RESISTANCE ABNORMALITY
END
#5
#6

FIG. 16

BEFORE SEQUENCE
C VOLTAGE
LIB N
LIB P
LIB PRE
#1
#2
#3
#4
#5
#6
601
602
603
604
605
CONSUMPTION CURRENT IN DISCHARGE CAN BE REDUCED

FIG. 17

BEFORE SEQUENCE
#1
#2
#3
#4
#5
#6
C VOLTAGE
DETERMINE THAT VOLTAGE HAS RISEN WHEN P RELAY WELDING IS DIAGNOSED
LIB N
LIB P
LIB PRE
601
602
603
604
604
604
605
605
605
605
605
605
605
300V
270V
240V
210V
180V
150V
120V
90V
60V
30V
0V
-30V
-60V
-90V
360A
330A
300A
270A
240A
210A
180A
150A
120A
90A
60A
30A
0A
-30A
0s
1s
2s
3s
4s
5s
6s
7s
8s

FIG. 18
START
P10
V>Vth1?
YES
NO
P20
LIB N OFF
P30
START DISCHARGE
P40
800 ms ELAPSED
P50
V<Vth2?
YES
NO
P51
V<Vth3?
YES
NO
P52
DETERMINE WELDING OF LIB Pre
P60
DETERMINE WELDING OF LIB N
P70
DETERMINE LIB VOLTAGE ABNORMALITY
P80
STOP DISCHARGE
END
P90
LIB Pre ON
P100
800 ms ELAPSED
P110
Vth4<V<Vth5?
YES
NO
P120
LIB P OFF
P130
800 ms ELAPSED
P140
V<Vth6?
YES
NO
P170
DETERMINE WELDING OF LIB P
P180
DETERMINE PRECHARGE RESISTANCE ABNORMALITY
P240
NORMAL COMPLETION PROCESS
P270
STOP DISCHARGE
END

FIG. 19

START
#1
P10
V>Vth1?
NO
YES
DETERMINE LIB VOLTAGE ABNORMALITY
P70
LIB N OFF
P20
START DISCHARGE @10A
P30a
800 ms ELAPSED
P40
#2
V<Vth2?
P50
NO
YES
DETERMINE WELDING OF LIB N
P60
STOP DISCHARGE
P80
END
LIB Pre ON
P90
800 ms ELAPSED
P100
Vth4<V<Vth5?
P110
NO
YES
TURN FLAG 1 ON
P180a
#3
LIB P OFF
P120
800 ms ELAPSED
P130
V<Vth6?
P140
NO
YES
DETERMINE WELDING OF LIB P
P170
#4
STOP DISCHARGE
P141
START DISCHARGE @15A
P142
LIB P ON
P150
800 ms ELAPSED
P160
A
STOP DISCHARGE
P190
END
#5

FIG. 20

#5
#6
A
P200a
Vth8<V<Vth9?
YES
NO
P201
IS FLAG 1 TURNED ON ?
NO
YES
P210
LIB Pre OFF
P220
800 ms ELAPSED
P230
V<Vth7?
YES
NO
P240
NORMAL COMPLETION PROCESS
P250
DETERMINE WELDING OF LIB Pre
P261
IS FLAG 1 TURNED ON ?
YES
NO
P262
DETERMINE DISCHARGE ABNORMALITY
P263
DETERMINE PRECHARGE RESISTANCE ABNORMALITY
P270
STOP DISCHARGE
END

BEFORE SEQUENCE
#1
#2
#3
#4
#5
#6
C VOLTAGE
VOLTAGE DIFFERENCE
LIB N
LIB P
LIB PRE
DISCHARGE CURRENT
INCREASE IN DISCHARGE CURRENT
601
602
603
604
605

FIG. 21

FIG. 22
#1
#2
#3
#4
#5
START
V>Vth1?
P10
YES
NO
DETERMINE LIB VOLTAGE ABNORMALITY
P70
LIB N OFF
P20
START DISCHARGE @10A
P30a
800 ms ELAPSED
P40
V<Vth2?
P50
YES
NO
DETERMINE WELDING OF LIB N
P60
STOP DISCHARGE
P80
END
Vth10<V<Vth11?
P53
YES
NO
TURN FLAG 2 ON
P54
LIB Pre ON
P90
800 ms ELAPSED
P100
Vth4<V<Vth5?
P110
YES
NO
TURN FLAG 1 ON
P180a
LIB P OFF
P120
800 ms ELAPSED
P130
V<Vth6?
P140
YES
NO
DETERMINE WELDING OF LIB P
P170
STOP DISCHARGE
P141
START DISCHARGE @15A
P142
LIB P ON
P150
800 ms ELAPSED
P160
A
STOP DISCHARGE
P190
END

FIG. 23
A
P200a
Vth8<V<Vth9?
YES
NO
P201
IS FLAG 1 TURNED ON ?
YES
NO
P264
IS FLAG 2 TURNED ON ?
YES
NO
P210
LIB Pre OFF
P220
800 ms ELAPSED
P230
V<Vth7?
YES
NO
P240
NORMAL COMPLETION PROCESS
P250
DETERMINE WELDING OF LIB Pre
DETERMINE CAPACITANCE ABNORMALITY OF CAPACITOR
P265
P261
IS FLAG 1 TURNED ON ?
YES
NO
DETERMINE DISCHARGE ABNORMALITY
P262
DETERMINE PRECHARGE RESISTANCE ABNORMALITY
P263
P270
STOP DISCHARGE
END
#5
#6

Europäisches
Patentamt
European
Patent Office
Office européen
des brevets

# EUROPEAN SEARCH REPORT

Application Number
EP 14 18 0184

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | JP 2000 278802 A (TOYOTA MOTOR CORP) 6 October 2000 (2000-10-06) * abstract; figures 1-3 * | 1-7 | INV. H01H47/00 ADD. B60L3/00 G01R31/327 |
| A | WO 2006/121144 A1 (TOYOTA MOTOR CO LTD [JP]; HIRASAWA TAKAHIKO [JP]) 16 November 2006 (2006-11-16) * page 5, line 28 - page 23, line 27; figures 1-4 * | 1-7 | |
| A | EP 1 610 355 A1 (NEC LAMILION ENERGY LTD [JP] NEC CORP [JP]; FUJI HEAVY IND LTD [JP]) 28 December 2005 (2005-12-28) * paragraph [0020] - paragraph [0031] * | 1-7 | |
| A | EP 2 141 792 A1 (TOYOTA MOTOR CO LTD [JP]) 6 January 2010 (2010-01-06) * paragraph [0017] - paragraph [0054]; figures 1-5 * | 1-7 | |
| A | US 2011/221374 A1 (MAEBARA TSUNEO [JP] ET AL) 15 September 2011 (2011-09-15) * sentence 0126, paragraph 0057; figures 1-3 * | 1-7 | TECHNICAL FIELDS SEARCHED (IPC): H01H B60L G01R |
| A | JP 2007 252082 A (TOYOTA MOTOR CORP) 27 September 2007 (2007-09-27) * abstract; figures 1, 3 * | 1-7 | |

The present search report has been drawn up for all claims

1

| Place of search | Date of completion of the search | Examiner |
|---|---|---|
| Munich | 19 December 2014 | Rubio Sierra, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 14 18 0184

This annex lists the patent family members relating to the patent documents cited in the above-mentioned European search report. The members are as contained in the European Patent Office EDP file on
The European Patent Office is in no way liable for these particulars which are merely given for the purpose of information.

19-12-2014

| Patent document cited in search report | Publication date | Patent family member(s) | Publication date |
|---|---|---|---|
| JP 2000278802 A | 06-10-2000 | NONE | |
| WO 2006121144 A1 | 16-11-2006 | BR PI0606158 A2 | 26-05-2009 |
| | | CN 101171656 A | 30-04-2008 |
| | | EP 1880401 A1 | 23-01-2008 |
| | | JP 4539431 B2 | 08-09-2010 |
| | | JP 2006320079 A | 24-11-2006 |
| | | KR 20070104619 A | 26-10-2007 |
| | | RU 2330344 C1 | 27-07-2008 |
| | | US 2008002322 A1 | 03-01-2008 |
| | | WO 2006121144 A1 | 16-11-2006 |
| EP 1610355 A1 | 28-12-2005 | CN 1768407 A | 03-05-2006 |
| | | EP 1610355 A1 | 28-12-2005 |
| | | JP 4572168 B2 | 27-10-2010 |
| | | KR 20060014029 A | 14-02-2006 |
| | | US 2006021098 A1 | 26-01-2006 |
| | | WO 2004088696 A1 | 14-10-2004 |
| EP 2141792 A1 | 06-01-2010 | CN 101669277 A | 10-03-2010 |
| | | EP 2141792 A1 | 06-01-2010 |
| | | JP 4697180 B2 | 08-06-2011 |
| | | JP 2008278560 A | 13-11-2008 |
| | | US 2010045104 A1 | 25-02-2010 |
| | | WO 2008132949 A1 | 06-11-2008 |
| US 2011221374 A1 | 15-09-2011 | CN 102195504 A | 21-09-2011 |
| | | JP 4962583 B2 | 27-06-2012 |
| | | JP 2011188712 A | 22-09-2011 |
| | | US 2011221374 A1 | 15-09-2011 |
| JP 2007252082 A | 27-09-2007 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2000278802 A
- WO 2004088696 A